# EUROPEAN PATENT SPECIFICATION

(11) **EP 4 571 283 B1**
(45) Date of publication and mention of the grant of the patent: **28.10.2026**
(21) Application number: 23892758.6
(22) Date of filing: 15.12.2023
(51) Int. Cl.: G01M 3/26, G01L 5/00, G01M 3/32, G01M 3/36, G01M 99/00, G01N 3/12, G01R 31/36, H01M 10/42

(54) **BATTERY TEST TOOLING, AND USE METHOD AND CONTROL METHOD FOR BATTERY TEST TOOLING**
BATTERIEPRÜFGERÄT SOWIE VERFAHREN ZUR VERWENDUNG UND ZUR STEUERUNG EINES BATTERIEPRÜFGERÄTS
ÉQUIPEMENT DE TEST DE BATTERIES, AINSI QUE PROCÉDÉ D'UTILISATION ET PROCÉDÉ DE COMMANDE DE CET ÉQUIPEMENT

(30) Priority: 08.10.2023 CN 202311288355
(43) Date of publication of application: 18.06.2025
(73) Proprietor: Contemporary Amperex Technology (Hong Kong) Limited, Central, Central And Western District (HK)
(72) Inventor: WU, Kai, Ningde, Fujian 352100 (CN); YU, Yingfeng, Ningde, Fujian 352100 (CN); LIAN, Dengwei, Ningde, Fujian 352100 (CN); ZHANG, Ning, Ningde, Fujian 352100 (CN); ZHOU, Hailun, Ningde, Fujian 352100 (CN); ZHONG, Huiying, Ningde, Fujian 352100 (CN); LIU, Xiaolong, Ningde, Fujian 352100 (CN); WEI, Tiecheng, Ningde, Fujian 352100 (CN); GUO, Pengfei, Ningde, Fujian 352100 (CN)
(74) Representative: Gong, Jinping
(86) International application number: PCT/CN2023/139254
(87) International publication number: WO 2025/076992

(56) References cited:
- CN-A- 114 798 695
- CN-A- 114 798 695
- CN-A- 115 326 305
- CN-A- 115 541 145
- CN-A- 115 931 249
- CN-A- 116 296 082
- CN-A- 117 030 153
- CN-B- 115 265 941
- CN-U- 211 452 728
- CN-U- 217 845 518
- CN-U- 217 845 518
- CN-U- 218 254 704
- CN-U- 218 674 072
- KR-B1- 101 981 048

## Description

### Cross-Reference to Related Application

The present disclosure is based on and claims priority to Chinese patent application No. 202311288355.0, filed on October 08, 2023 and entitled "BATTERY TEST TOOLING, AND USE METHOD AND CONTROL METHOD FOR BATTERY TEST TOOLING".

### Technical Field

The present disclosure relates to the field of battery technology, and in particular to battery test tooling as specified in any of claims 1-2, a use method for the battery test tooling as specified in any of claims 3-4, and a control method for battery test tooling as specified in any of claims 5-7.

### Background

New energy batteries are increasingly used in life and industry. For example, new energy vehicles equipped with batteries have been widely used, and in addition, batteries are increasingly used in the field of energy storage and the like. CN211452728U relates to an electric vehicle battery tray air tightness testing equipment. CN115931249A relates to an airtightness testing device for a battery guard plate. CN217845518U relates to a general battery pack airtightness detection tool. CN114798695A relates to a decommissioned wind power blade cutting device. CN116296082A mentions pressure sensor elements. CN115326305A mentions a pressure sensor. CN115541145A mentions that a pressure sensor is used to detect the pressure change value. CN115265941B mentions a pressure sensor.

In different application scenarios, various performance requirements for batteries are different, and the required batteries should also be different in shape, whereas no matter what shapes the batteries are in, they all need to be tested for airtightness during the production process. In the related art, corresponding airtightness test tooling is designed separately for different batteries, which leads to poor compatibility of the tooling for airtightness test of batteries.

### Summary of the Invention

The present disclosure provides battery test tooling, and a use method and a control method for battery test tooling, which can improve the versatility of the battery test tooling.

The first aspect of the present disclosure provides battery test tooling as specified in any of claims 1-2 comprising: a bracket, at least two sets of driving assemblies, and pressing members, wherein the driving assemblies are mounted on the bracket; and each set of driving assembly is provided with the pressing member, a pressing face on the pressing member that is away from the bracket being used to abut against a battery to be tested; and each of the pressing members being movable in a direction away from or approaching the bracket under the drive of the driving assembly. The battery test tooling further comprises first pressure sensors, the first pressure sensors being provided on the pressing face on each of the pressing members, and the first pressure sensors being used to monitor a pressure to which the pressing face is subjected when the pressing member abuts against the battery to be tested. The battery test tooling further comprises a controller, the first pressure sensors being electrically coupled to the controller, and the controller being configured to receive first pressure data monitored by the first pressure sensors and determine a test state of the battery to be tested according to the first pressure data; wherein the controller being configured to determine a test state of the battery to be tested according to the first pressure data comprises: being configured to judge that the test state of the battery to be tested is normal when the first pressure data is greater than a test pressure value and a duration in which the first pressure data is greater than the test pressure value is less than or equal to a preset length of time; and being configured to perform, when the test state of the battery to be tested is normal, fitting processing on an interfering test value based on the test pressure value, the interfering test value being the first pressure data corresponding to the duration.

Since a bracket is provided, it is possible to provide various parts in the battery test tooling on the bracket, so as to mount and carry the various parts with the bracket; and at least two sets of driving assemblies are provided, and it is possible to fix the driving assemblies to the bracket, and it is also possible to provide a pressing member on each set of driving assembly, so that the battery test tooling has at least two pressing members; in this way, it is possible to control each set of driving assembly to move independently according to different shapes of the battery to be tested in order to put each pressing member in motion independently, and it is possible to put different pressing members in motion towards the battery to be tested by different distances by each set of driving assembly in order to enable each pressing member to move to fit and abut against the abutting surface of the battery to be tested. Therefore, by applying the battery test tooling provided in the embodiments of the present disclosure, it is possible to control different pressing members to move independently according to the shapes of the abutting surfaces of different batteries to be tested, so as to cause the abutting surface of a battery to be tested to be abutted against all by the pressing members, so that the battery test tooling can be used for testing of batteries to be tested of different shapes, which can then improve the versatility of the battery test tooling.

In some embodiments not according to the invention, the driving assembly comprises an axial driving member, the pressing member being connected to the bracket via the axial driving member, and the axial driving member being used to drive the pressing member to move in a direction away from or approaching the bracket.

Due to the provision of the axial driving member in the driving assembly, the axial driving member can perform linear reciprocating movements, and thus can drive the pressing member to also perform linear reciprocating movements. In this way, it is possible to drive the pressing member connected to the axial driving member by the axial driving member in each set of driving assembly to move independently towards the battery to be tested, so that the individual pressing members can be moved by different distances; and it is also possible, according to the size and shape of the battery to be tested, to select part of the pressing members to be adapted to the size of the battery to be tested, wherein this part of the pressing members are driven to move independently by means of the axial driving members separately connected to this part of the pressing members, then the other axial driving members and pressing members can be kept immobile at standby positions, so as to not only adapt to different batteries to be tested, but also to save driving energy.

In some embodiments not according to the invention, the driving assembly further comprises a connecting member, the pressing member being connected to the axial driving member via the connecting member.

Since a connecting member is provided between the axial driving member and the pressing member, a connection structure matching a connection structure already existing on the axial driving member may be provided on the connecting member according to the connection structure that the axial driving member has, in order to facilitate the connection between the connecting member and the axial driving member. A corresponding connection structure may also be provided between the connecting member and the pressing member according to a desired movement or connection manner between the pressing member and the connecting member, so as to connect the pressing member and the connecting member. This facilitates the connection of the pressing member and the axial driving member without being limited by the existing connection structure on the axial driving member.

In some embodiments not according to the invention, a detachment structure is provided between the pressing member and the connecting member, the pressing member and the connecting member being detachably connected via the detachment structure.

Since a detachment structure is provided between the pressing member and the connecting member, a quick connection between the pressing member and the connecting member can be realized, which can facilitate the quick mounting and detachment of a plurality of pressing members, so that the required number of pressing members and the mounting positions of the pressing members can be selected according to the size and shape of the battery to be tested, thereby enabling quick switching of the battery test tooling so as to be adapted with the battery to be tested, which can then improve the efficiency of testing the battery to be tested.

In some embodiments not according to the invention, a movable connection structure is provided between the pressing member and the connecting member, the pressing member being rotatable relative to the connecting member via the movable connection structure.

Since a movable connection structure is provided between the connecting member and the pressing member, it is possible to rotate the pressing member with respect to the axis of the connecting member, and it is also possible to swing the pressing member with respect to the axis of the connecting member. In the process of contacting the pressing member with the abutting surface of the battery to be tested, the pressing member may adaptively adjust its attitude through the movable connection structure according to the shape of the abutting surface, so that a good contact is formed between the pressing member and the abutting surface of the battery to be tested.

In some embodiments not according to the invention, at least two of the pressing members are arranged in an array.

Since at least two pressing members are provided in the battery test tooling in an array arrangement, it is made convenient to select a corresponding part of the pressing members, or all of the pressing members, according to the shape of different batteries to be tested, in order to drive this part of the pressing members or all of the pressing members by the driving assemblies to separately abut against the abutting surface of the battery to be tested.

Since the first pressure sensors are provided on the pressing face of each of the pressing members, during the airtightness test of the battery to be tested, the change of the pressure inside the battery to be tested can be monitored by each first pressure sensor. The first pressure sensors can monitor the change in the pressure of the battery to be tested in real time when the pressure in the battery to be tested is subjected to an abrupt change due to an external interference. Each of the first pressure sensors is electrically coupled to the controller, and thus it is possible to judge, by analyzing the pressure values monitored by the first pressure sensors, whether the abrupt change in pressure within the battery to be tested results from external interference or from a quality problem of the battery to be tested itself. Thus, the data of the abrupt change in pressure resulting from external interference can be processed so that the airtightness test can be continued for the battery to be tested, without the need for another airtightness test after an inspection of the battery to be tested is performed, whereby the efficiency of testing the battery to be tested can be improved, so as to improve the efficiency of production.

In a possible implementation of the present disclosure, the battery test tooling further comprises an airtightness apparatus and a second pressure sensor, the airtightness apparatus being used to perform an airtightness test on the battery to be tested, and each of the first pressure sensors being electrically coupled to the airtightness apparatus; and the second pressure sensor being electrically coupled to the airtightness apparatus for monitoring an air pressure inside the battery to be tested.

Since an airtightness apparatus is provided in the battery test tooling, test steps such as inflation can be performed by the airtightness apparatus for the battery to be tested; and the first pressure sensors are electrically coupled to the airtightness apparatus, and thus the airtightness apparatus can be controlled according to the pressure data monitored by the first pressure sensors to start the corresponding airtightness test step for the battery to be tested; at the same time, a second pressure sensor is provided and the second pressure sensor is electrically coupled to the airtightness apparatus, and thus the airtightness apparatus can be controlled according to data of the air pressure inside the cavity of the battery to be tested that is monitored by the second pressure sensor to stop the corresponding airtightness test step.

In a possible implementation of the present disclosure, the structure of the second pressure sensor is adapted to the structure at a gas outlet of the battery to be tested, and the second pressure sensor is connectable at the gas outlet of the battery to be tested.

Since the structure of the second pressure sensor is set to adapt to the structure at the gas outlet of the battery to be tested, it is made convenient to connect the second pressure sensor to the gas outlet of the battery to be tested in order to monitor the air pressure inside the cavity of the battery to be tested undergoing an airtightness test.

Since a controller is provided, it is possible to judge the test state of the battery to be tested by the controller according to the acquired first pressure data, so that the number of times that the battery to be tested is inspected and the airtightness test is re-performed because the data monitored in the process of the airtightness test has an abrupt change point can be reduced.

In some embodiments not according to the invention, the battery test tooling further comprises a moving assembly, the moving assembly being provided on a side of the bracket that faces the driving assemblies, each set of driving assembly being mounted on the moving assembly and each set of driving assembly being movable under the drive of the moving assembly.

Since a moving assembly is provided on the bracket, and each set of driving assembly is provided on the moving assembly to put each set of driving assembly in motion by the moving assembly, the pressing member connected to the driving assembly can also be put in motion together, so that according to different placement positions of different batteries to be tested on the battery test tooling and different structural shapes of different batteries to be tested, each pressing member can be moved to a corresponding position above the battery to be tested by the moving assembly, thus making the battery test tooling applicable to batteries to be tested of different structural shapes.

In some embodiments not according to the invention, the moving assembly comprises a longitudinal guiding assembly and a longitudinal driving member, the longitudinal guiding assembly being mounted on the bracket, and the driving assemblies being slidably connected to the longitudinal guiding assembly, and one end of the longitudinal driving member being connected to the bracket, and the other end being connected to the driving assemblies; and the driving assemblies being movable in an extension direction of the longitudinal guiding assembly under the drive of the longitudinal driving member.

Since a longitudinal guiding assembly and a longitudinal driving member are provided, the driving assemblies can be slidably connected to the bracket via the longitudinal guiding assembly, and the driving assemblies can be driven by the longitudinal driving member to move along the longitudinal guiding assembly, and thus the pressing members can be put in motion by the driving assemblies in a third direction, so as to enable each of the pressing members to be at a different position in the third direction.

In some embodiments not according to the invention, the moving assembly further comprises a transverse guiding assembly and a transverse driving member, the transverse guiding assembly being slidably mounted on the longitudinal guiding assembly, the driving assemblies being slidably mounted on the transverse guiding assembly so as to be slidably connected to the longitudinal guiding assembly, and one end of the transverse driving member being connected to the transverse guiding assembly and the other end being connected to the driving assemblies; and the driving assemblies being movable in an extension direction of the transverse guiding assembly under the drive of the transverse driving member, wherein the extension direction of the transverse guiding assembly is at an angle to the extension direction of the longitudinal guiding assembly.

Since a transverse guiding assembly and a transverse driving member are provided and the transverse guiding assembly is slidably mounted on the longitudinal guiding assembly, the driving assemblies can be slidably mounted on the transverse guiding assembly to slidably connect the driving assemblies to the longitudinal guiding assembly; and the driving assemblies may be driven by the transverse driving member to put the pressing members in motion in a second direction, and at the same time, the transverse guiding assembly may be driven by the longitudinal driving member to move, so as to put the pressing members in motion in the third direction, so that each of the pressing members may be not only in a different position in the second direction, but also in a different position in the third direction.

A second aspect of the present disclosure provides a use method for battery test tooling as specified in any of claims 3-4, wherein the battery test tooling comprises an airtightness apparatus, driving assemblies, and pressing members provided on the driving assemblies, the use method comprising: using a transport member to place a battery to be tested on a test station corresponding to the battery test tooling; using the driving assemblies to perform a driving action to put the pressing members in motion in a direction approaching the battery to be tested until the pressing members abut against the battery to be tested, wherein a pressing face of the pressing member that is close to the battery to be tested is provided with first pressure sensors, the first pressure sensors being used to monitor a pressure value to which the pressing member is subjected; and using the airtightness apparatus to perform an airtightness test on the battery to be tested.

Since a transport member is used to carry the battery to be tested, the speed of carrying the battery to be tested can be increased, and the accuracy of the placement position of the battery to be tested can also be increased; and the pressing members are put in motion by the driving assemblies, so that the pressing members can be made to abut against the abutting surface of the battery to be tested, whereby after the pressing members abut against the abutting surface of the battery to be tested, the pressing members can apply acting force on the battery to be tested in order to restrict a large deformation of the battery to be tested in the process of the test; and at the same time, a corresponding airtightness test of the battery to be tested is performed by the airtightness apparatus to determine whether the airtightness of the battery to be tested meets the design requirements, so that the battery to be tested with substandard airtightness can be excluded, so as to improve the quality of the production of the battery.

In a possible implementation of the present disclosure, the battery test tooling comprises at least two sets of driving assemblies, each set of driving assembly being provided with the pressing member, the use method further comprising: determining, according to the shape of the battery to be tested, target pressing members among the pressing members, wherein the target pressing members are arranged to form a shape adapted to an abutting surface of the battery to be tested; and removing standby pressing members among the pressing members in the battery test tooling, the pressing members comprising the standby pressing members and the target pressing members.

Since the required target pressing members are determined according to the shape of the battery to be tested and the standby pressing members are removed, during the airtightness test of the battery to be tested, it is only necessary to control the target pressing members to move to abut against the battery to be tested without the need to consider the standby pressing members; furthermore, after the standby pressing members have been removed, the weight of structural members in the battery test tooling can be reduced, thus facilitating the control of the movement of the battery test tooling.

A third aspect of the present disclosure provides a control method for battery test tooling as specified in any of claims 5-7, which is applied to a controller, wherein the battery test tooling comprises an airtightness apparatus, driving assemblies, and pressing members provided on the driving assemblies, the control method comprising: controlling, in response to a delivery request, a transport member to place a battery to be tested on a test station corresponding to the battery test tooling; controlling, in response to a test request, the driving assemblies to perform a driving action to put the pressing members in motion in a direction approaching the battery to be tested until the pressing members abut against the battery to be tested, wherein a pressing face of the pressing member that is close to the battery to be tested is provided with a first pressure sensor; controlling the airtightness apparatus to perform an airtightness test on the battery to be tested; and receiving first pressure data monitored by the first pressure sensors and determining a test state of the battery to be tested according to the first pressure data; where the determining a test state of the battery to be tested according to the first pressure data comprises: judging that the test state of the battery to be tested is normal when the first pressure data is greater than a test pressure value and a duration in which the first pressure data is greater than the test pressure value is less than or equal to a preset length of time; and performing, when the test state of the battery to be tested is normal, fitting processing on an interfering test value based on the test pressure value, the interfering test value being the first pressure data corresponding to the duration.

Since a transport member is controlled to carry the battery to be tested, the speed of carrying the battery to be tested can be increased, and the accuracy of the placement position of the battery to be tested can also be increased; and the driving assemblies are controlled to put the pressing members in motion, so that the pressing members can be made to abut against the abutting surface of the battery to be tested, whereby after the pressing members abut against the abutting surface of the battery to be tested, the pressing members can apply acting force on the battery to be tested in order to restrict a large deformation of the battery to be tested in the process of the test; at the same time, the airtightness apparatus is controlled to perform a corresponding airtightness test on the battery to be tested to determine whether the airtightness of the battery to be tested meets the design requirements, so that the battery to be tested with substandard airtightness can be excluded, so as to improve the quality of the production of the battery; moreover, the abrupt change point data during the airtightness test can be processed according to the first pressure data monitored by the first pressure sensors, so as to reduce the number of retests of the battery to be tested, and thus the efficiency of testing the battery to be tested can be improved, so as to improve the efficiency of production.

Since a judgment of whether the test state of the battery to be tested is normal or not is performed according to the duration in which the first pressure data is greater than the test pressure value versus the preset length of time, it is possible to quickly and easily determine whether abrupt changes in the test data of the battery to be tested are caused by external interference or due to the quality of the battery to be tested itself in the course of the airtightness test, so that abrupt change data resulting from external interference can be processed to reduce the number of airtightness tests on the battery to be tested of which the airtightness meets the design requirements.

In a possible implementation of the present disclosure, the battery test tooling comprises at least two sets of driving assemblies, each set of driving assembly being provided with the pressing member; and controlling the driving assemblies to perform a driving action to put the pressing members in motion in a direction approaching the battery to be tested until the pressing members abut against the battery to be tested comprises: controlling, when second pressure values are monitored by the first pressure sensors on target pressing members among the pressing members, the driving assemblies corresponding to the target pressing members to stop performing the driving action; and clearing, when the second pressure value is monitored by the first pressure sensor on each of the target pressing members, data of the second pressure value in each of the first pressure sensors.

Since the driving assemblies are controlled according to the second pressure values monitored by the first pressure sensors, it is possible to control the pressing members to stop moving immediately after the pressing members have come into contact with the battery to be tested, so that the risk of the pressing members generating large pressing pressures on the battery to be tested can be reduced.

In a possible implementation of the present disclosure, the battery test tooling further comprises a bracket and a moving assembly, the driving assemblies being mounted on the bracket, the bracket being mounted at a mounting station via the moving assembly, and the moving assembly being used to put the bracket in motion, the control method further comprising: determining movement position information of the moving assembly based on process parameters of the battery to be tested; and determining, based on the movement position information, detection position information of the battery test tooling with respect to the battery to be tested.

Since the movement position information of the moving assembly is determined according to the process parameters of the battery to be tested, and the detection position information of the battery test tooling with respect to the battery to be tested is determined according to the movement position information, the determined detection position information can be recorded and stored in the controller, and then when a battery to be tested of this type is subjected to an airtightness test, the detection position information corresponding to the battery to be tested can be retrieved, and the driving action of the driving members in the battery test tooling can be controlled by the detection position information. Thereby, repeated debugging work of the battery test tooling can be reduced to improve the efficiency of testing the battery to be tested.

In a possible implementation of the present disclosure, the control method further comprises: acquiring the detection position information in response to a test request; and controlling, based on the detection position information, the moving assembly to drive the bracket to move so as to put the pressing members in motion to preset positions corresponding to the battery to be tested.

Since the driving members in the moving assembly are controlled according to the detection position information to perform corresponding driving actions, the pressing members can be quickly put in motion to preset positions by the bracket so as to improve the efficiency of testing the battery to be tested.

### Description of Drawings

By reading the detailed description of the preferred implementations below, various other advantages and benefits will become apparent to those of ordinary skill in the art. The drawings are for the purpose of illustrating the preferred implementations only and are not to be considered a limitation to the present disclosure. Moreover, in all of the accompanying drawings, the same parts are indicated by the same reference numerals. In the drawings:
Fig. 1 is a structural schematic diagram I of battery test tooling provided in the present disclosure;
Fig. 2 is a structural schematic diagram of a movable connection structure in battery test tooling provided in the present disclosure;
Fig. 3 is a structural schematic diagram II of battery test tooling provided in the present disclosure;
Fig. 4 is a structural schematic diagram III of battery test tooling provided in the present disclosure;
Fig. 5 is a schematic diagram of a curve of pressure values monitored by first pressure sensors in battery test tooling provided in the present disclosure;
Fig. 6 is a structural schematic diagram IV of battery test tooling provided in the present disclosure;
Fig. 7 is a structural schematic diagram V of battery test tooling provided in the present disclosure;
Fig. 8 is a schematic flowchart I of a use method for battery test tooling provided in the present disclosure;
Fig. 9 is a schematic flowchart II of a use method for battery test tooling provided in the present disclosure;
Fig. 10 is a schematic flow chart I of a control method for battery test tooling provided in the present disclosure;
Fig. 11 is a schematic flow chart II of a control method for battery test tooling provided in the present disclosure;
Fig. 12 is a schematic flow chart III of a control method for battery test tooling provided in the present disclosure;
Fig. 13 is a schematic flow chart IV of a control method for battery test tooling provided in the present disclosure; and
Fig. 14 is a schematic flow chart V of a control method for battery test tooling provided in the present disclosure.

Description of reference numerals:
1 - bracket; 2 - driving assembly; 21 - axial driving member; 22 - connecting member; 3 - pressing member; 4 - first pressure sensor; 5 - moving assembly; 51 - longitudinal guiding assembly; 52 - transverse guiding assembly; 6 - movable connection structure; 61 - connecting rod; 62 - base; 63 - rotating ball; 7 - second pressure sensor; 8 - airtightness apparatus; 9 - battery to be tested; A - first direction; B - second direction; C - third direction.

### Detailed Description

Embodiments of the technical solutions of the present disclosure will be described in detail below in conjunction with the drawings. The following embodiments are only used to illustrate the technical solutions of the present disclosure more clearly, and are therefore used only as examples, and should not be used to limit the protection scope of the present disclosure.

Unless otherwise defined, all technical and scientific terms used herein have the same meaning as commonly understood by those skilled in the art to which the present disclosure belongs; the terms used herein are for the purpose of describing specific embodiments only, and are not intended to limit the present disclosure; the terms "comprising/including" and "having" and any variations thereof in the description of the present disclosure as well as in the above description of drawings are intended to cover a non-exclusive inclusion.

In the description of the embodiments of the present disclosure, the technical terms "first", "second", "third", and the like are used only to distinguish between different objects, and are not to be understood as indicating or implying a relative importance or implicitly specifying the number, particular order, or primary and secondary relation of the technical features indicated. In the description of the embodiments of the present disclosure, the meaning of "plurality of" is two or more, unless otherwise expressly and specifically defined.

Reference herein to "embodiment" means that a particular feature, structure, or characteristic described in connection with the example can be included in at least one example of the present disclosure. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present disclosure, the term "and/or" is only an association relationship for describing associated objects, indicating that three relationships may exist. For example, A and/or B may represent three situations: A exists alone, both A and B exist, and B exists alone. In addition, the character "/" herein generally means that the associated objects before and after it are in an "or" relationship.

In the description of the embodiments of the present disclosure, the technical terms "length", "width", "thickness", "upper", "lower", "front", "rear", "left", "right", "vertical", "horizontal", "top", "bottom", "inner", "outer", "circumferential", and the like indicate orientations or positional relationships based on the orientations or positional relationships shown in the drawings, and are intended only to facilitate and simplify the description of the embodiments of the present disclosure, and are not intended to indicate or imply that a device or element referred to must have a particular orientation, be constructed, operated and used in a particular orientation, and therefore should not be construed as limiting the embodiments of the present disclosure.

In the description of the embodiments of the present disclosure, unless otherwise expressly specified and defined, the technical terms "mounted", "linked", "connected", "fixed", and the like are to be understood broadly, and may, for example, be fixedly connected or detachably connected, or integrated; and may also be mechanically connected or electrically connected; and may be directly linked or indirectly linked through an intermediate medium, and may be internal communication or interaction between two elements. For those of ordinary skill in the art, the specific meanings of the above terms in the embodiments of the present disclosure can be understood according to specific situations.

In the description of the embodiments of the present disclosure, unless otherwise expressly specified and limited, the technical term "contact" is to be understood in a broad sense, as either a direct contact, a contact across an intermediate media layer, a contact with essentially no acting force between the two in contact, or a contact with an acting force between the two in contact.

Hereinafter, the present disclosure is described in detail.

Currently, new energy batteries are being used more and more widely in life and industry. New energy batteries are not only applied in energy storage power source systems such as water, fire, wind, and solar power stations, but also widely applied in electric transportation tools, such as electric bicycles, electric motorcycles, and electric vehicles, as well as many fields, such as military equipment and aerospace. With the continuous expansion of the application field of the power batteries, the market demand is also constantly expanding.

In the embodiments of the present disclosure, the battery may be a battery cell. A battery cell is a basic unit capable of mutual conversion of chemical and electrical energy, which can be used to make battery modules or packs, and thus be used to supply power to electrical apparatuses. The battery cell may be a secondary battery, which is a battery cell that can continue to be used by activating the active material by means of charging after the battery cell has been discharged. The battery cell may be a lithium-ion battery, a sodium-ion battery, a sodium-lithium-ion battery, a lithium-metal battery, a sodium-metal battery, a lithium-sulfur battery, a magnesium-ion battery, a nickel-metal hydride battery, a nickel-cadmium battery, a lead storage battery, and so forth, which is not limited in the embodiments of the present disclosure.

In different application scenarios, the shape of the battery used in different application scenarios varies due to limitations such as the mounting space of the battery. Regardless of the shape of the battery, in the production process, a number of tests need to be performed on the battery so that various aspects of the performance of the battery meets the usage requirements. For example, the battery is required to be subjected to an airtightness test.

In the related art, in the process of performing an airtightness test on a battery, due to the fact that different batteries have different shapes, and different connecting members are provided on the external surfaces of different batteries, in the process of performing an airtightness test on a battery, it is necessary to design a test tooling that is adapted to the shape and structure of the battery according to the shape and structure of the battery, so as to perform an airtightness test on the battery. Therefore, it is necessary to design a corresponding airtightness testing tooling according to each kind of battery shape, and it is also necessary to replace some of the parts in the airtightness testing tooling in the process of testing batteries of different shapes. Regarding designing corresponding airtightness test tooling for different battery shapes, on one hand, this increases the cost of production of the tooling, and on the other hand, since each type of airtightness test tooling is not universally applicable, it is necessary to replace the tooling during the test process, which lengthens the test cycle and thus affects the efficiency of production of the batteries.

In the process of airtightness testing of the battery, it is also susceptible to various types of interference that cause abrupt changes in the data monitored by the test device, so that it is likely to judge that there is an airtightness problem with the battery under test according to the abrupt change data points resulting from the external interference and that retesting of the battery under test is required. This can lead to a reduction in the production capacity of the production line, which can likewise affect the efficiency of production of the battery.

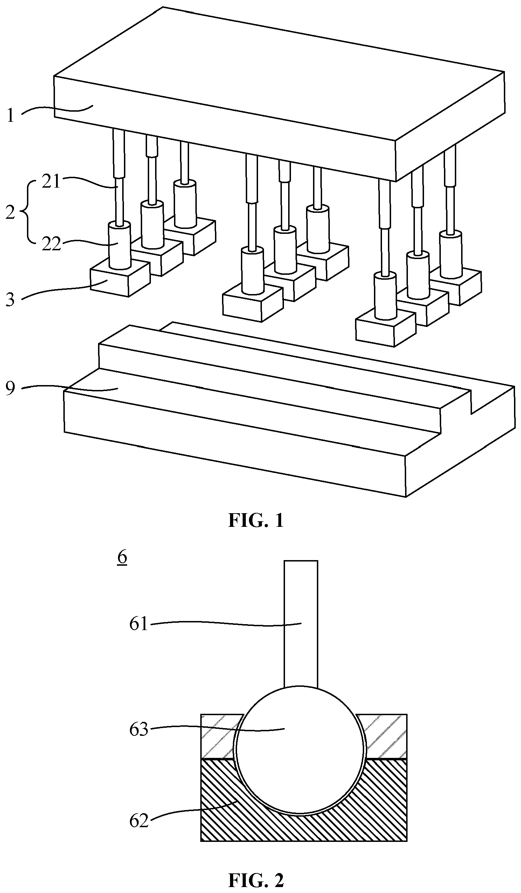

The embodiments of the present disclosure provide battery test tooling, with reference to Fig. 1, which Fig. 1 is a structural schematic diagram I of battery test tooling provided in the present disclosure. The battery test tooling comprises: a bracket, at least two sets of driving assemblies, and pressing members, wherein each set of driving assembly is mounted on the bracket; and each set of driving assembly is provided with the pressing member, a pressing face on the pressing member that is away from the bracket being used to abut against a battery to be tested; and each of the pressing members is movable in a direction away from or approaching the bracket under the drive of the driving assembly.

In the embodiments of the present disclosure, the bracket 1 may be a bracket 1 that plays a carrying role, wherein other parts in the battery test tooling may be provided on the bracket 1 so that various parts in the battery test tooling are carried by the bracket 1. For example, the bracket 1 may be provided in a plate-like structure to mount the at least two sets of driving assemblies 2 on the plate-like bracket 1.

In the embodiments of the present disclosure, the driving assemblies 2 are used to drive a movement of pressing members 3 in the battery test tooling to cause the pressing members 3 to move in a direction approaching the battery to be tested 9, or to move in a direction away from the battery to be tested 9. For example, the driving assembly 2 may be provided in a structural form comprising a driving member and a connecting member 22, wherein the driving member may be an air cylinder, an oil cylinder, an electric motor, or the like.

In the embodiments of the present disclosure, the surface on the pressing member 3 that is away from the bracket 1 is a pressing face on the pressing member 3, and the pressing member 3 is used to press against the surface of the battery to be tested 9, and the pressing member 3 can fit and abut against the surface of the battery to be tested 9 through the pressing face. The pressing member 3 may be provided in a block-like structure with a length and width of 25 mm, which means that the pressing face is a square with a side length of 25 mm, and the pressing member 3 may also be provided in a structural form of other sizes and shapes according to the size and shape of the battery to be tested 9, which is not limited in the embodiments of the present disclosure. A plurality of pressing members 3 may be driven by respective driving assemblies 2 so that the plurality of pressing members 3 are separately pressed against the upper cover of the battery to be tested 9, so that the battery to be tested 9 does not undergo a large expansion in the course of the airtightness test, which may result in a low test value of the airtightness test.

In the battery test tooling described above, since a bracket 1 is provided, it is possible to provide various parts in the battery test tooling on the bracket 1, so as to mount and carry the various parts with the bracket 1; and at least two sets of driving assemblies 2 are provided, and it is possible to fix the driving assemblies 2 to the bracket 1, and it is also possible to provide a pressing member 3 on each set of driving assembly 2, so that the battery test tooling has at least two pressing members 3; in this way, it is possible to control each set of driving assembly 2 to move independently according to different shapes of the battery to be tested 9 in order to put each pressing member 3 in motion independently, and it is possible to put different pressing members 3 in motion towards the battery to be tested 9 by different distances by each set of driving assembly 2 in order to enable each pressing member 3 to be moved to fit and abut against the abutting surface of the battery to be tested 9. Therefore, by applying the battery test tooling provided in the embodiments of the present disclosure, it is possible to control different pressing members 3 to move independently according to the shapes of the abutting surfaces of different batteries to be tested 9 in order to cause the abutting surface of a battery to be tested 9 to be abutted against all by the pressing members 3, so that the battery test tooling can be used for testing of batteries to be tested 9 of different shapes, which can then improve the versatility of the battery test tooling.

In some embodiments, as shown in Fig. 1, the driving assembly 2 may be provided in a structural form including an axial driving member 21, the pressing member 3 being connected to the bracket 1 via the axial driving member 21, and the axial driving member 21 being used to drive the pressing member 3 to move in a direction away from or approaching the bracket 1.

In the embodiments of the present disclosure, the axial driving member 21 may perform linear reciprocating movements to drive the pressing member 3 connected to the axial driving member 21 to perform linear reciprocating movements together. As an example, the axial driving member 21 may be an air cylinder or an oil cylinder, and the cylinder barrel of the air cylinder or oil cylinder may be fixedly connected to the bracket 1, and the pressing member 3 may be fixedly connected to the free end of the piston rod of the air cylinder or oil cylinder. The axial driving member 21 may also be in a structural form including a motor, a gear, and a rack. For example, the motor is fixedly connected to the bracket 1, the gear is mounted on the output shaft of the motor, and the rack is slidably provided on the bracket 1, and the rack is engaged with the gear, so that when the motor rotates in different directions, the rack can be driven by the gear to perform linear reciprocating movements. The structural form of the axial driving member 21 is not limited in the embodiments of the present disclosure.

In the above embodiment, due to the provision of the axial driving member 21 in the driving assembly 2, the axial driving member 21 can perform linear reciprocating movements, and thus can drive the pressing member 3 to also perform linear reciprocating movements. In this way, it is possible to drive the pressing member 3 connected to the axial driving member 21 by the axial driving member 21 in each set of driving assembly 2 to move independently towards the battery to be tested 9, so that the individual pressing members 3 can be moved by different distances; and it is also possible, according to the size and shape of the battery to be tested 9, to select part of the pressing members 3 to be adapted to the size of the battery to be tested 9, wherein this part of the pressing members 3 are driven to move independently by means of the axial driving members 21 separately connected to this part of the pressing members 3, then the other axial driving members 21 and pressing members 3 can be kept immobile at standby positions, so as to not only adapt to different batteries to be tested 9, but also to save driving energy.

In some embodiments, as shown in Fig. 1, the driving assembly 2 may be provided in a structural form that further comprises a connecting member 22, and the pressing member 3 is connected to the axial driving member 21 via the connecting member 22.

In the embodiments of the present disclosure, in order to facilitate the connection between the pressing member 3 and the axial driving member 21, a connecting member 22 may be provided, with one end of the connecting member 22 being provided with a structure adapted to the connection structure on the axial driving member 21. For example, the end portion of the piston rod of the air cylinder or the oil cylinder usually has an external thread, so an internal thread adapted to this external thread may be provided at one end of the connecting member 22, and the connecting member 22 may be fixedly connected to the axial driving member 21 by means of a threaded connection. The connection between the pressing member 3 and the connecting member 22 may also be implemented by means of a threaded connection, a snap-fit, a bonded connection or a welded connection. The structural shape of the connecting member 22 may be designed according to the overall structure of the battery test tooling and the movement path of the pressing member 3, etc. For example, the connecting member 22 is provided in a cylindrical structural shape, and a connection structure is provided on each of the two axial end faces of the connecting member 22 so as to connect the axial driving member 21 and the pressing member 3.

In the above embodiment, since a connecting member 22 is provided between the axial driving member 21 and the pressing member 3, a connection structure matching a connection structure already existing on the axial driving member 21 may be provided on the connecting member 22 according to the connection structure that the axial driving member 21 has, in order to facilitate the connection between the connecting member 22 and the axial driving member 21. A corresponding connection structure may also be provided between the connecting member 22 and the pressing member 3 according to a desired movement or connection manner between the pressing member 3 and the connecting member 22, so as to connect the pressing member 3 and the connecting member 22. This facilitates the connection of the pressing member 3 and the axial driving member 21 without being limited by the existing connection structure on the axial driving member 21.

In some embodiments, as shown in Fig. 1, a detachment structure may be provided between the pressing member 3 and the connecting member 22, so that the pressing member 3 and the connecting member 22 are detachably connected via the detachment structure.

In the embodiments of the present disclosure, in order to facilitate a rapid connection and a rapid detachment of the pressing member 3 and the connecting member 22, a detachable structure may be provided between the connecting member 22 and the pressing member 3. For example, if the detachment structure is provided in a threaded connection structure, then with the threaded connection structure, by means of screwing the pressing member 3, the pressing member 3 can be quickly connected to the axial driving member 21, or can be detached from the axial driving member 21. The detachment structure between the connecting member 22 and the pressing member 3 may also be provided as a self-locking quick joint, i.e., a plug-in joint structure that can be self-locked, wherein a plug of the self-locking quick joint is fixedly mounted on the pressing member 3, and a main body of the self-locking quick joint is fixedly mounted on the connecting member 22, so that the pressing member 3 can be quickly mounted and connected to the connecting member 22 by connecting the plug to the corresponding insertion hole on the body.

In the above embodiment, since a detachment structure is provided between the pressing member 3 and the connecting member 22, a quick connection between the pressing member 3 and the connecting member 22 can be realized, which can facilitate the quick mounting and detachment of a plurality of pressing members 3, so that the required number of pressing members 3 and the mounting positions of the pressing members 3 can be selected according to the size and shape of the battery to be tested 9, thereby enabling quick switching of the battery test tooling so as to be adapted with the battery to be tested 9, which can then improve the efficiency of testing the battery to be tested 9.

In some embodiments, a movable connection structure 6 may be provided between the pressing member 3 and the connecting member 22, the pressing member 3 being rotatable relative to the connecting member 22 via the movable connection structure 6.

In the embodiments of the present disclosure, in order to enable good pressing and contact between the pressing member 3 and different types of batteries to be tested 9, a movable connection structure 6 may be provided between the connecting member 22 and the pressing member 3, as shown in Fig. 2. For example, the movable connection structure 6 is provided in a structural form including a connecting rod 61, a base 62, and a rotating ball 63, wherein the base 62 has a spherical cavity adapted to the rotating ball 63, and the base 62 also has a cavity opening at one end thereof, the cavity opening being connected to the spherical cavity; the connecting rod 61 is connected to the rotating ball 63; and the rotating ball 63 is provided within the spherical cavity of the base 62 and the connecting rod 61 is made to extend from the cavity opening to the exterior of the base 62. In this way, the base 62 in the movable connection structure 6 can be fixedly connected to the pressing member 3, and the connecting rod 61 can be fixedly connected to the plug of the self-locking quick joint; or the base 62 can be fixedly connected to the plug of the self-locking quick joint, and the connecting rod 61 can be fixedly connected to the pressing member 3. For the specific structural form of the movable connection structure 6, and the specific setting positions of the movable connection structure 6 and the detachment structure between the pressing member 3 and the connecting member 22, no limitation will be made in the embodiments of the present disclosure.

As an example, part of the pressing members 3 and the corresponding driving assemblies 2 in the battery test tooling may be connected by the movable connection structures 6. For example, among the plurality of pressing members 3, the pressing members 3 that are located in middle positions are provided with the movable connection structures 6, while the pressing members 3 that are located in the periphery are connected to the driving assemblies 2 by means of detachment structures.

In the above embodiment, since a movable connection structure 6 is provided between the connecting member 22 and the pressing member 3, it is possible to rotate the pressing member 3 with respect to the axis of the connecting member 22, and it is also possible to swing the pressing member with respect to the axis of the connecting member 22. In the process of contacting the pressing member 3 with the abutting surface of the battery to be tested 9, the pressing member 3 may adaptively adjust its attitude through the movable connection structure 6 according to the shape of the abutting surface, so that a good contact is formed between the pressing member 3 and the abutting surface of the battery to be tested 9.

In some embodiments, as shown in Fig. 1, at least two pressing members 3 in the battery test tooling may be provided on the bracket 1 in an array arrangement.

In the embodiments of the present disclosure, the shape of the battery to be tested 9 is usually a regular shape, and the pressing members 3 in the battery test tooling may also be provided on the bracket 1 in a regular arrangement. For example, 9 pressing members 3 may be provided in the battery test tooling and the 9 pressing members 3 may be arranged in three rows by three columns so that the 9 pressing members 3 form a 3 x 3 array arrangement. Alternatively, 20 pressing members 3 may be provided in the test tooling and the 20 pressing members 3 may be arranged in four rows by five columns so that the 20 pressing members 3 form a 4 x 5 array arrangement. Further, 25 pressing members 3 may be provided in the battery test tooling and the 25 pressing members 3 may be arranged in five rows by five columns so that the 25 pressing members 3 form a 5 x 5 array arrangement. The embodiments of the present disclosure do not limit the specific number of the pressing members 3, and the specific arrangement manner of the plurality of pressing members 3 on the bracket 1.

In the above embodiment, since at least two pressing members 3 are provided in the battery test tooling in an array arrangement, it is made convenient to select a corresponding part of the pressing members 3, or **all** of the pressing members 3, according to the shape of different batteries to be tested 9, in order to drive this part of the pressing members 3 or **all** of the pressing members 3 by the driving assemblies 2 to separately abut against the abutting surface of the battery to be tested 9.

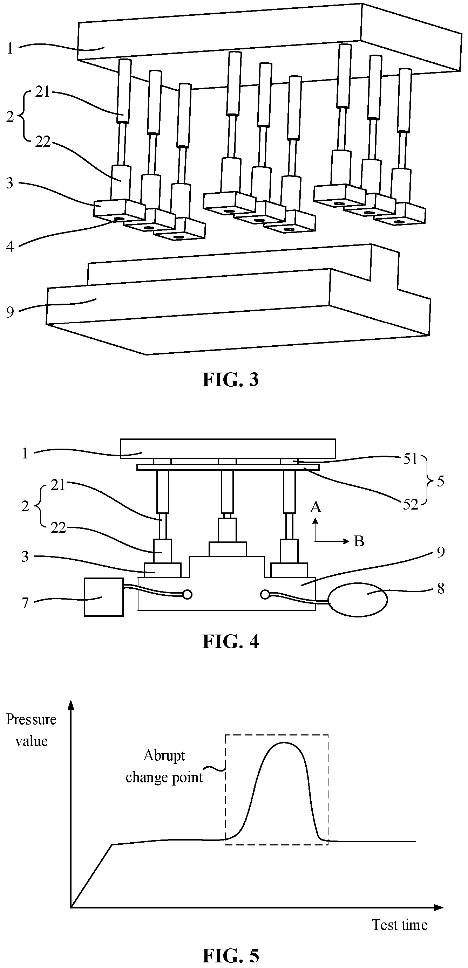

In some embodiments, referring to Fig. 3, Fig. 3 illustrates a structural schematic diagram II of battery test tooling provided in the present disclosure. A first pressure sensor 4 may also be provided on the pressing face on each of the pressing members 3 in the battery test tooling; and the first pressure sensor 4 is used to monitor a pressure to which the pressing face is subjected when the pressing member 3 abuts against the battery to be tested 9.

In the embodiments of the present disclosure, in order to facilitate monitoring the air pressure of the battery to be tested 9 during the airtightness test, the first pressure sensor 4 may be provided on the pressing face on the pressing member 3 that faces the battery to be tested 9, and the first pressure sensor 4 may be used to monitor the magnitude of the force applied on the pressing member 3 in the case of expansion of the battery to be tested 9. For example, the first pressure sensor 4 may be a thin-film pressure sensor, which only needs to be bonded to the pressing face on the pressing member 3. The first pressure sensor 4 may also be a pressure sensor of other structural forms, which is not limited in the embodiments of the present disclosure.

In the above embodiment, since the first pressure sensor 4 is provided on the pressing face of each of the pressing members 3, during the airtightness test of the battery to be tested 9, the change of the pressure inside the battery to be tested 9 can be monitored by each first pressure sensor 4. The first pressure sensors 4 can monitor the change in the pressure of the battery to be tested 9 in real time when the pressure in the battery to be tested 9 is subjected to an abrupt change due to an external interference. Each of the first pressure sensors 4 is electrically coupled to the controller, and thus it is possible to judge, by analyzing the pressure values monitored by the first pressure sensors 4, whether the abrupt change in pressure within the battery to be tested 9 results from external interference or from a quality problem of the battery to be tested 9 itself. Thus, the data of the abrupt change in pressure resulting from external interference can be processed so that the airtightness test can be continued for the battery to be tested 9, without the need for another airtightness test after an inspection of the battery to be tested 9 is performed, whereby the efficiency of testing the battery to be tested 9 can be improved, so as to improve the efficiency of production.

In some embodiments, referring to Fig. 4, Fig. 4 illustrates a structural schematic diagram III of battery test tooling provided in the present disclosure. The battery test tooling further comprises an airtightness apparatus 8 and a second pressure sensor 7, the airtightness apparatus 8 being used to perform an airtightness test on the battery to be tested 9, and each of the first pressure sensors 4 being electrically coupled to the airtightness apparatus 8; and the second pressure sensor 7 being electrically coupled to the airtightness apparatus 8 for monitoring an air pressure inside the battery to be tested 9.

In the embodiments of the present disclosure, the airtightness apparatus 8 may be connected to an inflation port of the battery to be tested 9 via a gas delivery pipeline, so that a certain volume of dry and unadulterated gas may be inflated to the interior of the cavity of the battery to be tested 9. The second pressure sensor 7 may be connected to the exhaust port of the battery to be tested 9 to monitor the value of the air pressure inside the cavity of the battery to be tested 9.

As an example, each of the first pressure sensors 4 may be electrically coupled to the airtightness apparatus 8, and after the required pressing members 3 have come into contact with the battery to be tested 9, the first pressure sensors 4 can monitor a change in pressure, and on the one hand, the corresponding axial driving members 21 can be controlled to stop the driving action, and on the other hand, after the required pressing members 3 are all in contact with the battery to be tested 9, the airtightness apparatus 8 receives signals from the first pressure sensors 4 indicating that **all** of the required pressing members 3 have been in contact with the battery to be tested 9, and in response to the signals, the airtightness apparatus 8 can start performing the corresponding airtightness test on the battery to be tested 9.

In another example, the second pressure sensor 7 may be electrically coupled to the airtightness apparatus 8, and during the process of performing the airtightness test on the battery to be tested 9 by the airtightness apparatus 8, the airtightness apparatus 8 may be controlled to stop inflation or the like according to the value of the air pressure inside the cavity of the battery to be tested 9 that is monitored by the second pressure sensor 7.

In the above embodiment, since an airtightness apparatus 8 is provided in the battery test tooling, test steps such as inflation can be performed by the airtightness apparatus 8 for the battery to be tested 9; and the first pressure sensors 4 are electrically coupled to the airtightness apparatus 8, and thus the airtightness apparatus 8 can be controlled according to the pressure data monitored by the first pressure sensors 4 to start the corresponding airtightness test step for the battery to be tested 9; at the same time, a second pressure sensor 7 is provided and the second pressure sensor 7 is electrically coupled to the airtightness apparatus 8, and thus the airtightness apparatus 8 can be controlled according to data of the air pressure inside the cavity of the battery to be tested 9 that is monitored by the second pressure sensor 7 to stop the corresponding airtightness test step.

In some embodiments, the structure of the second pressure sensor 7 may be set to adapt to the structure at the gas outlet of the battery to be tested 9, and the second pressure sensor 7 is connectable at the gas outlet of the battery to be tested 9.

In the embodiments of the present disclosure, the structure of the second pressure sensor 7 can be set according to the structural form of the gas outlet of the battery to be tested 9, so as to connect the second pressure sensor 7 to the gas outlet of the battery to be tested 9. For example, according to the structural form of the explosion-proof valve of the battery to be tested 9, the second pressure sensor 7 may be set to be of a structure connected to the pressure relief valve, so as to connect the second pressure sensor 7 to the explosion-proof valve of the battery to be tested 9.

In the above embodiment, since the structure of the second pressure sensor 7 is set to adapt to the structure at the gas outlet of the battery to be tested 9, it is made convenient to connect the second pressure sensor 7 to the gas outlet of the battery to be tested 9 in order to monitor the air pressure inside the cavity of the battery to be tested 9 undergoing an airtightness test.

In some embodiments, the battery test tooling provided in the embodiments of the present disclosure further comprises a controller, the first pressure sensors 4 being electrically coupled to the controller, and the controller being configured to receive first pressure data monitored by the first pressure sensors 4 and determine a test state of the battery to be tested 9 according to the first pressure data.

In the embodiments of the present disclosure, the controller may be a computer device or a computer module or the like having a data processing capability, such as a computer, a server and the like. Each of the first pressure sensors 4 is electrically coupled to the controller, and the first pressure sensor 4 monitors a first pressure generated by the battery to be tested 9 against the pressing member 3 due to expansion during the airtightness test, and transmits first pressure data of the first pressure monitored to the controller, and the controller may determine a test state of the battery to be tested 9 according to the received first pressure data. The test state may be that the test process is normal, indicating that the performance of the battery to be tested 9 meets the design requirements, or the test state may be that the test process fails, indicating that the performance of the battery to be tested 9 does not meet the design requirements.

As an example, referring to Fig. 5, Fig. 5 illustrates a curve of pressure values monitored by the first pressure sensors 4. For example, during the process of the airtightness test of the battery to be tested 9, when the box body of the battery to be tested 9 suddenly expands, the battery to be tested 9 is pressed down manually, or the battery to be tested 9 is subjected to vibration and other interference, the curve of pressure values in the dashed box in Fig. 5 will accordingly produce an abrupt change point, which means that an abrupt change of the first pressure data will take place, and after the interference is eliminated, the first pressure data will return to the normal value level. Then the controller may judge according to the duration of the first pressure data for the abrupt change whether the first pressure data for the abrupt change indicates an abrupt change point. For example, the judgment condition for the duration of the abrupt change point is set to be less than or equal to 10 s, and then when the duration of the abrupt change point does not exceed 10 s, the test process for the battery to be tested 9 is judged to be normal, and this judgment result is fed back to the airtightness apparatus 8. Thereby, the number of times that the battery to be tested 9 is inspected and the airtightness test is re-performed because the data monitored in the process of the airtightness test has an abrupt change point can be reduced.

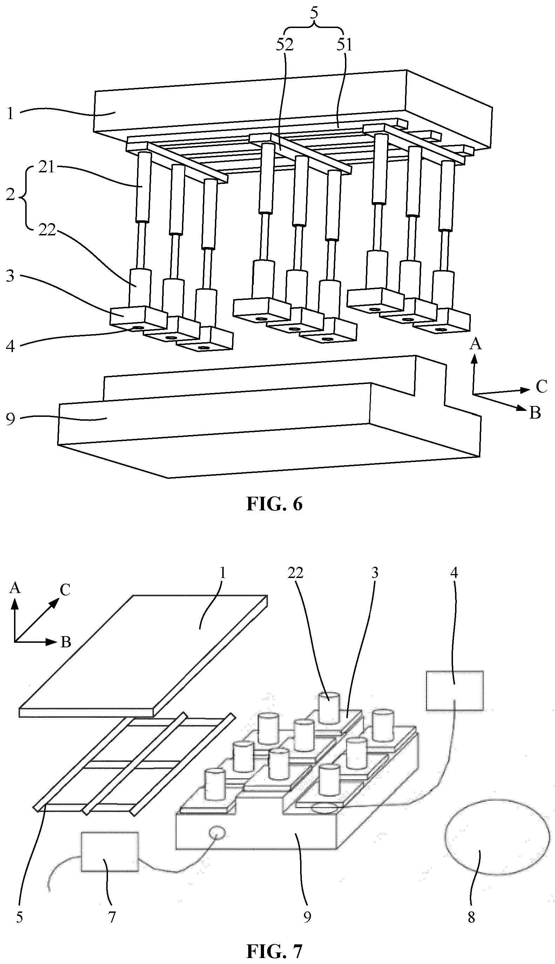

In some embodiments, referring to Figs. 6 and 7, Fig. 6 is a structural schematic diagram IV of battery test tooling provided in the present disclosure; and Fig. 7 is a structural schematic diagram V of battery test tooling provided in the present disclosure. As shown in Figs. 4, 6, and 7, a moving assembly 5 may be provided in the battery test tooling, the moving assembly 5 being provided on a side of the bracket 1 that faces the driving assemblies 2, each set of driving assembly 2 being mounted on the moving assembly 5 and each set of driving assembly 2 being movable under the drive of the moving assembly 5.

In the embodiments of the present disclosure, the bracket 1 may be mounted on the station where the battery test tooling is located, and then the moving assembly 5 is mounted on the bracket 1. The moving assembly 5 may be provided in a structural form including a driving member and a moving member. Each set of driving assembly 2 is mounted on the moving member, and the driving member is connected to the moving member or the driving assembly 2, so as to drive the moving member or the driving assembly 2 to move by the driving member so that the driving assembly 2 provided on the moving member can thus be put in motion, or to directly drive the driving assembly 2 to move so that the pressing member 3 provided on the driving assembly 2 can be put in motion together.

In the above embodiment, since a moving assembly 5 is provided on the bracket 1, and each set of driving assembly 2 is provided on the moving assembly 5 to put each set of driving assembly 2 in motion by the moving assembly 5, the pressing member 3 connected to the driving assembly 2 can also be put in motion together, so that according to different placement positions of different batteries to be tested 9 on the battery test tooling and different structural shapes of different batteries to be tested 9, each pressing member 3 can be moved to a corresponding position above the battery to be tested 9 by the moving assembly 5, thus making the battery test tooling applicable to batteries to be tested 9 of different structural shapes.

In some embodiments, as shown in Figs. 4, 6, and 7, the moving assembly 5 may be provided in a structural form including a longitudinal guiding assembly 51 and a longitudinal driving member, the longitudinal guiding assembly 51 being mounted on the bracket 1, and the driving assemblies 2 being slidably connected to the longitudinal guiding assembly 51, and one end of the longitudinal driving member being connected to the bracket 1 and the other end being connected to the driving assemblies 2; and the driving assemblies 2 being movable in an extension direction of the longitudinal guiding assembly 51 under the drive of the longitudinal driving member.

In the embodiments of the present disclosure, a longitudinal guiding assembly 51 may be provided in a plane perpendicular to the axis of the axial driving member 21, and a longitudinal driving member may be provided correspondingly, and the driving assemblies 2 may be driven by the longitudinal driving member to make reciprocating movements in a third direction C.

As an example, the longitudinal guiding assembly 51 may be provided in a structural form including at least two longitudinal guide rails. For example, three longitudinal guide rails may be provided, each of which extends along the third direction C. The three longitudinal guide rails are all fixedly mounted in parallel to one side of the bracket 1 that faces the driving assemblies 2. A plurality of sets of driving assemblies 2 may be provided on each of the longitudinal guide rails, for example, 3 sets of driving assemblies 2 on one longitudinal guide rail.

In a further example, the longitudinal driving member may be a driving member such as an air cylinder, an oil cylinder or a linear motor, and one end of the longitudinal driving member may be connected to the corresponding longitudinal guide rail to connect the longitudinal driving member to the bracket 1, and the other end of the longitudinal driving member to a set of driving assembly 2, so that one set of driving assembly 2 may be driven by each longitudinal driving member to move along the longitudinal guide rail, so as to put the pressing member 3 provided on the driving assembly 2 in motion along the third direction C.

In the above embodiment, since a longitudinal guiding assembly 51 and a longitudinal driving member are provided, the driving assemblies 2 can be slidably connected to the bracket 1 via the longitudinal guiding assembly 51, and the driving assemblies 2 can be driven by the longitudinal driving member to move along the longitudinal guiding assembly 51, and thus the pressing members 3 can be put in action by the driving assemblies 2 in the third direction C, so as to enable each of the pressing members 3 to be at a different position in the third direction C.

In some embodiments, as shown in Figs. 4, 6, and 7, a structural member including a transverse guiding assembly 52 and a transverse driving member may also be provided in the moving assembly 5, the transverse guiding assembly 52 being slidably mounted on the longitudinal guiding assembly 51, the driving assemblies 2 being slidably mounted on the transverse guiding assembly 52 so as to be slidably connected to the longitudinal guiding assembly 51, and one end of the transverse driving member being connected to the transverse guiding assembly 52 and the other end being connected to the driving assemblies 2; and the driving assemblies being movable in an extension direction of the transverse guiding assembly 52 under the drive of the transverse driving member, wherein the extension direction of the transverse guiding assembly 52 is at an angle to the extension direction of the longitudinal guiding assembly 51.

In the embodiments of the present disclosure, a transverse guiding assembly 52 may also be provided in a plane perpendicular to the axis of the axial driving member 21, that is, perpendicular to the first direction A, and a transverse driving member may be provided correspondingly, and the driving assemblies 2 provided on the transverse guiding assembly 52 may be driven by the transverse driving member to make reciprocating movements in a second direction B.

As an example, the transverse guiding assembly 52 may be provided in a structural form including a plurality of transverse guide rails. For example, three transverse guide rails may be slidably provided on the three longitudinal guide rails, wherein the three transverse guide rails all extend along the second direction B, and the three transverse guide rails are all independently slidably provided on the longitudinal guide rails. A plurality of sets of driving assemblies 2 may be slidably mounted on each of the transverse guide rails, e.g., three sets of driving assemblies 2 may be slidably mounted on one transverse guide rail, and each set of driving assembly 2 may be independently slidably mounted along that transverse guide rail. The other end of the longitudinal driving member in the above embodiment may be connected to a transverse guide rail to drive that transverse guide rail to move in the third direction C, thereby putting all the driving assemblies 2 provided on that transverse guide rail in motion in the third direction C together. Here, the second direction B and the third direction C have an included angle between them, wherein the included angle may be set to 90°, or the included angle between the second direction B and the third direction C may be set to other angles as needed.

In a further example, the transverse driving member may be a driving member such as an air cylinder, an oil cylinder, a linear motor, or a servo motor, and one end of the transverse driving member may be connected to the corresponding transverse guide rail, and the other end of the transverse driving member may be connected to a set of driving assembly 2, so that one set of driving assembly 2 may be driven by each transverse driving member to move along the transverse guide rail, so as to put the pressing member 3 provided on the driving assembly 2 in motion along the second direction B In this way, it is possible to enable the driving assemblies 2 on each transverse guide rail to move independently in the second direction B, and to enable the driving assemblies 2 located on the same transverse guide rail to move together in the third direction C, so that different pressing members 3 can be put in motion to different positions.

In the above embodiment, since a transverse guiding assembly 52 and a transverse driving member are provided and the transverse guiding assembly 52 is slidably mounted on the longitudinal guiding assembly 51, the driving assemblies 2 can be slidably mounted on the transverse guiding assembly 52 to slidably connect the driving assemblies 2 to the longitudinal guiding assembly 51; and the driving assemblies 2 may be driven by the transverse driving member to put the pressing members 3 in motion in a second direction B, and at the same time, the transverse guiding assembly 52 may be driven by the longitudinal driving member to move, so as to put the pressing members 3 in motion in the third direction C, so that each of the pressing members 3 may be not only in a different position in the second direction B, but also in a different position in the third direction C.

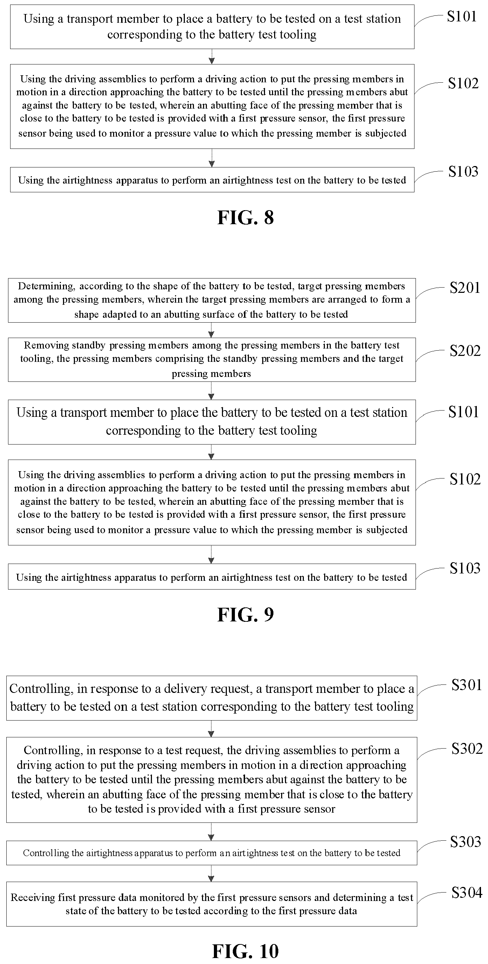

The embodiments of the present disclosure further provide a use method for battery test tooling, wherein the battery test tooling comprises an airtightness apparatus, driving assemblies, and pressing members provided on the driving assemblies, with reference to Fig. 8, which Fig. 8 is a schematic flowchart I of the use method for battery test tooling provided in the present disclosure, the method comprising the following steps S101 to S103.

S101: using a transport member to place a battery to be tested on a test station corresponding to the battery test tooling.

In some embodiments, the battery to be tested may be a battery pack, wherein the battery pack comprises a box body and battery cells, the battery cells or battery modules being accommodated in the box body. The battery cell may be a secondary battery, which is a battery cell that can continue to be used by activating the active material by means of charging after the battery cell has been discharged. The battery cell may be a lithium-ion battery, a sodium-ion battery, a sodium-lithium-ion battery, a lithium-metal battery, a sodium-metal battery, a lithium-sulfur battery, a magnesium-ion battery, a nickel-metal hydride battery, a nickel-cadmium battery, a lead storage battery, and so forth, which is not limited in the embodiments of the present disclosure.

In some embodiments, the batteries to be tested with different structural shapes have corresponding test stations on the battery test tooling, which are used to place the batteries to be tested so as to facilitate the fixed placement of the batteries to be tested in the set positions.

In some embodiments, in order to quickly place the battery to be tested on the test station, the battery to be tested can be placed on the test station corresponding to the battery test tooling by a transport member, which can be a transport trolley, a robotic arm capable of grasping and carrying the battery to be tested, and the like.

S102: using the driving assemblies to perform a driving action to put the pressing members in motion in a direction approaching the battery to be tested until the pressing members abut against the battery to be tested, wherein a pressing face of the pressing member that is close to the battery to be tested is provided with a first pressure sensor, the first pressure sensor being used to monitor a pressure value to which the pressing member is subjected.

In some embodiments, the pressing member is provided on the driving assembly, and a first pressure sensor is provided on a pressing face of the pressing member that is close to the battery to be tested, and the first pressure sensor may monitor a pressure on the pressing member that is applied to the pressing member by the battery to be tested.

In some embodiments, after the battery to be tested is placed on the test station, the driving assemblies in the battery test tooling may be used, and by controlling the driving assemblies to perform a driving action, the driving assemblies can put the pressing members in motion in the direction approaching the battery to be tested and, when pressure values are monitored by the first pressure sensors, a control signal may be sent to the driving assemblies by the first pressure sensors to cause the driving assemblies to stop performing the driving action so that the pressing members can be made abut against the abutting surface of the battery to be tested.

S103: using the airtightness apparatus to perform an airtightness test on the battery to be tested.

In some embodiments, after the pressing members abut against the abutting surface of the battery to be tested, the airtightness apparatus can be controlled to perform an airtightness test on the battery to be tested. Before this, it is necessary to connect the airtightness apparatus to the battery to be tested. For example, the interior of the cavity of the battery to be tested can be inflated by the airtightness apparatus to create a certain air pressure inside the battery to be tested, so that the airtightness of the battery to be tested can be tested to determine whether it meets the design requirements.

In the above embodiment, since a transport member is used to carry the battery to be tested, the speed of carrying the battery to be tested can be increased, and the accuracy of the placement position of the battery to be tested can also be increased; and the pressing members are driven by the driving assemblies to move, so that the pressing members can be made to abut against the abutting surface of the battery to be tested, whereby after the pressing members abut against the abutting surface of the battery to be tested, the pressing members can apply acting force on the battery to be tested in order to restrict a large deformation of the battery to be tested in the process of the test; and at the same time, a corresponding airtightness test of the battery to be tested is performed by the airtightness apparatus to determine whether the airtightness of the battery to be tested meets the design requirements, so that the battery to be tested with substandard airtightness can be excluded, so as to improve the quality of the production of the battery.

Referring to Fig. 9, Fig. 9 is a schematic flowchart II of a use method for battery test tooling provided in the present disclosure. Based on Fig. 8, the battery test tooling comprises at least two sets of driving assemblies, each set of driving assembly being provided with a pressing member; and the use method in Fig. 8 further comprises steps S201 to S202.

S201: determining, according to the shape of the battery to be tested, target pressing members among the pressing members, wherein the target pressing members are arranged to form a shape adapted to an abutting surface of the battery to be tested.

In some embodiments, since different batteries to be tested have different shapes, which means that different types of batteries to be tested do not have the same abutting surface, it is possible to determine, according to the shapes and sizes of the abutment surfaces of different batteries to be tested, target pressing members among the plurality of pressing members, wherein the target pressing members are arranged to form a shape that is adapted to the shape of the abutment surface of the battery to be tested.

As an example, when the size of the abutting surface of the battery to be tested is adapted to the rectangle formed by the arrangement of 9 pressing members, these 9 pressing members may be used as the target pressing members. When the size of the abutting surface of the battery to be tested is adapted to the rectangle formed by the arrangement of 20 pressing members, these 20 pressing members may be used as the target pressing members.

S202: removing standby pressing members among the pressing members in the battery test tooling, the pressing members comprising the standby pressing members and the target pressing members.

In some embodiments, after determining the target pressing members among the pressing members, the standby pressing members in the battery test tooling may be removed, which means that the pressing members that are not required to be used in the current test process may be removed. Here, the standby pressing members and the target pressing members constitute all of the pressing members.

In the above embodiment, since the required target pressing members are determined according to the shape of the battery to be tested and the standby pressing members are removed, during the airtightness test of the battery to be tested, it is only necessary to control the target pressing members to move to abut against the battery to be tested without the need to consider the standby pressing members; furthermore, after the standby pressing members have been removed, the weight of structural members in the battery test tooling can be reduced, thus facilitating the control of the movement of the battery test tooling.

At the same time, the embodiments of the present disclosure further provide a control method for battery test tooling, which is applied to a controller, wherein the battery test tooling comprises an airtightness apparatus, driving assemblies, and pressing members provided on the driving assemblies, with reference to Fig. 10, which Fig. 10 is a schematic flowchart I of the control method for battery test tooling provided in the present disclosure, the method comprising the following steps S301 to S304.

S301: controlling, in response to a delivery request, a transport member to place a battery to be tested on a test station corresponding to the battery test tooling.

In some embodiments, the delivery request may be generated in response to a test operation of the user for the battery to be tested, or may be generated in response to a carry operation of the user for the battery to be tested. The embodiments of the present disclosure do not limit the scenario in which the delivery request is generated.

In some embodiments, the batteries to be tested with different structural shapes have corresponding test stations on the battery test tooling, which are used to place the batteries to be tested so as to facilitate the fixed placement of the batteries to be tested in the set positions. In order to quickly place the battery to be tested on the test station, the battery to be tested can be placed on the test station corresponding to the battery test tooling by a transport member, which can be a transport trolley, a robotic arm capable of grasping and carrying the battery to be tested, and the like.

In some embodiments, after receiving the delivery request, the controller may send a control signal to the transport member to control the transport member to transport the battery to be tested to a position corresponding to the battery test tooling, and to place the battery to be tested at the corresponding test station.

S302: controlling, in response to a test request, the driving assemblies to perform a driving action to put the pressing members in motion in a direction approaching the battery to be tested until the pressing members abut against the battery to be tested, wherein a pressing face of the pressing member that is close to the battery to be tested is provided with a first pressure sensor.

In some embodiments, the test request may be generated in response to a test operation of the user for the battery to be tested, or may be generated in response to a retest operation of the user for the battery to be tested. The embodiments of the present disclosure do not limit the scenario in which the test request is generated.

In some embodiments, the pressing member is provided on the driving assembly, and a first pressure sensor is provided on a pressing face of the pressing member that is close to the battery to be tested, and the first pressure sensor may monitor a pressure on the pressing member that is applied to the pressing member by the battery to be tested.

In some embodiments, after the battery to be tested is placed on the test station and the controller receives the test request, the controller may send a control signal to the driving assemblies to control the driving assemblies to perform a driving action, then the driving assemblies can put the pressing members in motion in the direction approaching the battery to be tested and, when pressure values are monitored by the first pressure sensors, a control signal may be sent to the driving assemblies by the first pressure sensors to cause the driving assemblies to stop performing the driving action so that the pressing members can be made abut against the abutting surface of the battery to be tested.

S303: controlling the airtightness apparatus to perform an airtightness test on the battery to be tested.

In some embodiments, after the required pressing members all abut against the abutting surface of the battery to be tested, the controller may send a control signal to the airtightness apparatus to control the airtightness apparatus to perform an airtightness test on the battery to be tested. Before this, it is necessary to connect the airtightness apparatus to the battery to be tested. For example, the interior of the cavity of the battery to be tested can be inflated by the airtightness apparatus to create a certain air pressure inside the battery to be tested, so that the airtightness of the battery to be tested can be tested to determine whether it meets the design requirements.

S304: receiving first pressure data monitored by the first pressure sensors and determining a test state of the battery to be tested according to the first pressure data.

In some embodiments, each of the first pressure sensors is electrically coupled to the controller, and the first pressure sensor monitors a first pressure generated by the battery to be tested against the pressing member due to expansion during the airtightness test, and transmits first pressure data of the first pressure monitored to the controller, and the controller may determine a test state of the battery to be tested according to the received first pressure data. The test state may be that the test process is normal, indicating that the performance of the battery to be tested meets the design requirements, or the test state may be that the test process fails, indicating that the performance of the battery to be tested does not meet the design requirements.

In the above embodiment, since a transport member is controlled to carry the battery to be tested, the speed of carrying the battery to be tested can be increased, and the accuracy of the placement position of the battery to be tested can also be increased; and the driving assemblies are controlled to drive the pressing members to move, so that the pressing members can be made to abut against the abutting surface of the battery to be tested, whereby after the pressing members abut against the abutting surface of the battery to be tested, the pressing members can apply acting force on the battery to be tested in order to restrict a large deformation of the battery to be tested in the process of the test; at the same time, the airtightness apparatus is controlled to perform a corresponding airtightness test on the battery to be tested to determine whether the airtightness of the battery to be tested meets the design requirements, so that the battery to be tested with substandard airtightness can be excluded, so as to improve the quality of the production of the battery; moreover, the abrupt change point data during the airtightness test can be processed according to the first pressure data monitored by the first pressure sensors, so as to reduce the number of retests of the battery to be tested, and thus the efficiency of testing the battery to be tested can be improved, so as to improve the efficiency of production.

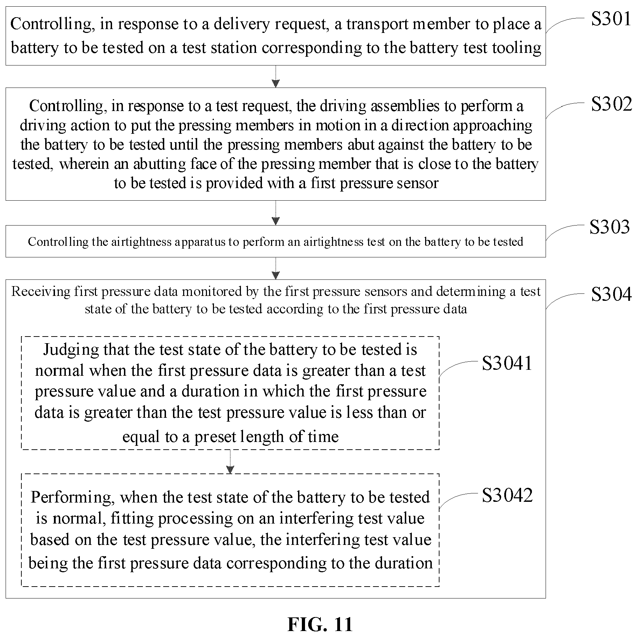

Referring to Fig. 11, Fig. 11 is a schematic flow chart II of a control method for battery test tooling provided in the present disclosure. Based on Fig. 10, step S304 in Fig. 10 is realized by the following steps S3041 to S3042.

S3041: judging that the test state of the battery to be tested is normal when the first pressure data is greater than a test pressure value and a duration in which the first pressure data is greater than the test pressure value is less than or equal to a preset length of time.

In some embodiments, as shown in Fig. 5, after charging a certain volume of gas into the interior of the cavity of the battery to be tested by the airtightness apparatus, the first pressure sensors may monitor a test pressure value, which is a pressure-holding air pressure value of the interior of the cavity of the battery to be tested during the test process, i.e., the pressure value of the near-horizontal section as shown in Fig. 5.

In some embodiments, during the process of the airtightness test of the battery to be tested, when the box body of the battery to be tested suddenly expands, the battery to be tested is pressed down manfully, or the battery to be tested is subjected to vibration and other interference, the curve of pressure values in the dashed box in Fig. 5 will accordingly produce an abrupt change point, which means that an abrupt change of the first pressure data will take place, and the interfering test value that lasts for a period of time will be produced in the first pressure data, and after the interference is eliminated, the first pressure data returns to the normal value level, that is, to the test pressure value. Then, the controller may judge according to the duration of the first pressure data for the abrupt change whether the first pressure data for the abrupt change indicates an abrupt change point. For example, the judgment condition for the duration of the abrupt change point is set to be less than or equal to 10s, which means that the preset length of time is set to 10s. Then, when the duration of the abrupt change point does not exceed 10 s, the test state of the battery to be tested during the test process is judged to be normal, and the judgment result is fed back to the airtightness apparatus.

S3042: performing, when the test state of the battery to be tested is normal, fitting processing on an interfering test value based on the test pressure value, the interfering test value being the first pressure data corresponding to the duration.

In some embodiments, when the test state of the battery to be tested is judged to be normal, fitting processing is performed on an interfering test value in the first pressure data according to the test pressure value, which means that fitting processing is performed on abrupt change point data generated in the first pressure data resulting from external interference. The interfering data is the first pressure data corresponding to the duration from the change in the first pressure data resulting from the external interference to the return to the test pressure value. As an example, the interfering test value may be processed as data consistent with the test pressure value.

In the above embodiment, since a judgment of whether the test state of the battery to be tested is normal or not is performed according to the duration in which the first pressure data is greater than the test pressure value versus the preset length of time, it is possible to quickly and easily determine whether abrupt changes in the test data of the battery to be tested are caused by external interference or due to the quality of the battery to be tested itself in the course of the airtightness test, so that abrupt change data resulting from external interference can be processed to reduce the number of airtightness tests on the battery to be tested of which the airtightness meets the design requirements.

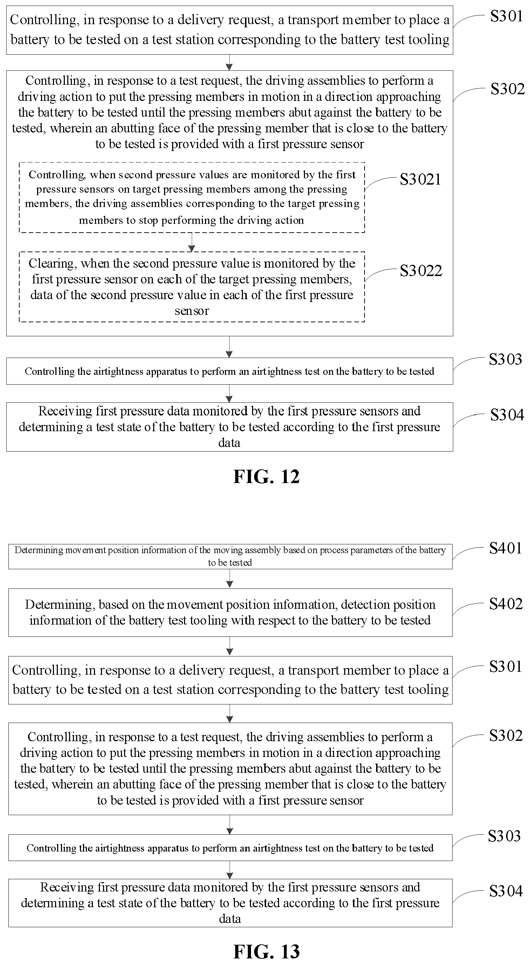

Referring to Fig. 12, Fig. 12 is a schematic flow chart III of a control method for battery test tooling provided in the present disclosure. The battery test tooling comprises at least two sets of driving assemblies, each set of driving assembly being provided with a pressing member. Based on Fig. 10, the step S302 in Fig. 10 can be realized by the following steps S3021 to S3022.

S3021: controlling, when second pressure values are monitored by the first pressure sensors on target pressing members among the pressing members, the driving assemblies corresponding to the target pressing members to stop performing the driving action.

In some embodiments, during the movement of the target pressing members in the direction approaching the battery to be tested, second pressure values may be monitored by the first pressure sensors when the target pressing members come into contact with the battery to be tested, then the first pressure sensors may immediately feed back signals to the controller to cause the controller to send a control signal to the corresponding driving assemblies to control the driving assemblies corresponding to the target pressing members to stop executing the driving action, thereby maintaining the target pressing members at the positions in contact with the battery to be tested.

S3022: clearing, when the second pressure value is monitored by the first pressure sensor on each of the target pressing members, data of the second pressure value in each of the first pressure sensor.

In some embodiments, after each of the target pressing members is in contact with the battery to be tested, the controller may receive second pressure values sent by the first pressure sensors of all of the target pressing members, then the controller may clear all of the received second pressure values. At this time, the battery to be tested is not inflated internally, and after clearing the second pressure values, the first pressure data can be monitored and acquired by the first pressure sensors after the battery to be tested is inflated.

In the above embodiment, since the driving assemblies are controlled according to the second pressure values monitored by the first pressure sensors, it is possible to control the pressing members to stop moving immediately after the pressing members have come into contact with the battery to be tested, so that the risk of the pressing members generating large pressing pressures on the battery to be tested can be reduced.

Referring to Fig. 13, Fig. 13 is a schematic flow chart IV of a control method for battery test tooling provided in the present disclosure. The battery test tooling further comprises a bracket and a moving assembly, the driving assemblies being mounted on the bracket, the bracket being mounted at a mounting station via the moving assembly, and the moving assembly being used to put the bracket in motion. Based on Fig. 10, the control method in Fig. 10 further comprises steps S401 to S402.

S401: determining movement position information of the moving assembly based on process parameters of the battery to be tested.

In some embodiments, batteries to be tested with different shapes have different process parameters, which means that different types of batteries to be tested have different lengths, heights and widths as well as shapes of the abutting surfaces. Then, the positions to which the pressing members are required to be moved will also be different. The movement position information for the moving assembly can be determined according to the process parameters of different types of batteries to be tested, i.e., determining the position to which each driving member in the moving assembly corresponding to that type of battery to be tested is required to move, and the position data for that driving member when it moves to that position can be recorded.

S402: determining, based on the movement position information, detection position information of the battery test tooling with respect to the battery to be tested.

In some embodiments, after determining the movement position information for the moving assembly corresponding to different types of batteries to be tested, the detection position information of the battery test tooling with respect to the batteries to be tested may be determined according to the movement position information for **all** the driving members in the moving assembly, that is, determining, for each type of battery to be tested, data of the position to which each driving member in the battery test tooling is required to move. The position data for all the driving members is used as the detection position information for a corresponding type of battery to be tested, and the detection position information can be used to control the driving members in the battery test tooling to perform the corresponding driving action.

In the above embodiment, since the movement position information of the moving assembly is determined according to the process parameters of the battery to be tested, and the detection position information of the battery test tooling with respect to the battery to be tested is determined according to the movement position information, the determined detection position information can be recorded and stored in the controller, and then when a battery to be tested of this type is subjected to an airtightness test, the detection position information corresponding to the battery to be tested can be retrieved, and the driving action of the driving members in the battery test tooling can be controlled by the detection position information. Thereby, repeated debugging work of the battery test tooling can be reduced to improve the efficiency of testing the battery to be tested.

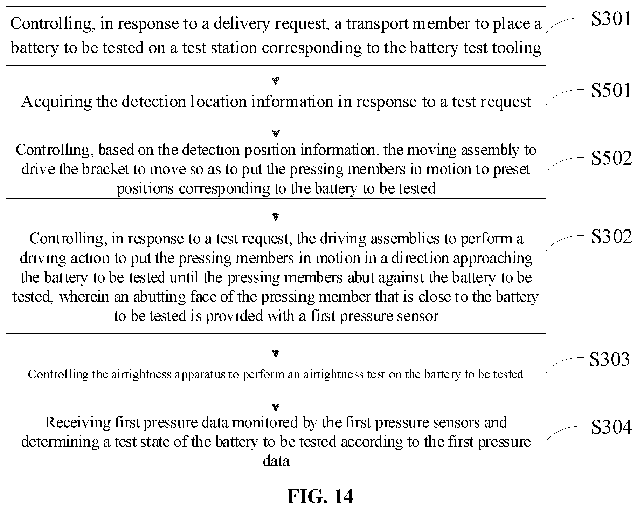

Referring to Fig. 14, Fig. 14 is a schematic flow chart V of a control method for battery test tooling provided in the present disclosure. Based on Fig. 10, the control method in Fig. 10 further comprises steps S501 to S502.

S501: acquiring the detection position information in response to a test request.

In some embodiments, after placing the battery to be tested at the test station, the controller may acquire, in response to the test request, detection position information corresponding to the battery to be tested.

S502: controlling, based on the detection position information, the moving assembly to drive the bracket to move so as to put the pressing members in motion to preset positions corresponding to the battery to be tested.

In some embodiments, after the controller acquires the detection position information corresponding to the battery to be tested, it may send a control signal to the moving assembly in the battery test tooling according to the detection position information to control the driving member in the moving assembly to perform a corresponding driving action, and thus can drive the bracket to move, so that the bracket puts the pressing members in motion to the preset positions corresponding to the battery to be tested. The preset position may be a position directly above the battery to be tested, and has a certain spacing distance from the battery to be tested.

In the above embodiment, since the driving members in the moving assembly are controlled according to the detection position information to perform corresponding driving actions, the pressing members can be quickly driven to preset positions by the bracket so as to improve the efficiency of testing the battery to be tested.

The above embodiments are merely used for illustrating rather than limiting the technical solutions of the present disclosure. Although the present disclosure has been described in detail with reference to the above various embodiments, those of ordinary skill in the art should understand that the technical solutions specified in the above various embodiments can still be modified, or some or all of the technical features therein can be equivalently substituted; and such modifications or substitutions do not make the essence of the corresponding technical solutions depart from the scope of the technical solutions of the various embodiments of the present disclosure, which shall fall within the scope of the appended claims. In particular, the technical features mentioned in the various embodiments can be combined in any manner as long as there is no structural conflict.

### Industrial utility

The embodiments of the present disclosure provide battery test tooling, and a use method and a control method for battery test tooling, which can improve the versatility of the battery test tooling.

## Claims

1. Battery test tooling, comprising:
a bracket (1);
at least two sets of driving assemblies (2), the driving assemblies (2) being mounted on the bracket (1); and
pressing members (3), wherein the pressing member (3) is provided on each set of said driving assembly (2), a pressing face on the pressing member (3) that is away from the bracket (1) being used to abut against a battery to be tested (9); and each said pressing member (3) being movable in a direction away from or approaching the bracket (1) under the drive of the driving assembly (2);
**characterized in that** the battery test tooling further comprises first pressure sensors (4), the first pressure sensors (4) being provided on the pressing face on each of the pressing members (3), and the first pressure sensors (4) being used to monitor a pressure to which the pressing face is subjected when the pressing member (3) abuts against the battery to be tested (9); and
wherein the battery test tooling further comprises a controller, the first pressure sensors (4) being electrically coupled to the controller, and the controller being configured to receive first pressure data monitored by the first pressure sensors (4) and determine a test state of the battery to be tested (9) according to the first pressure data;
wherein the controller being configured to determine a test state of the battery to be tested (9) according to the first pressure data comprises:
being configured to judge that the test state of the battery to be tested (9) is normal when the first pressure data is greater than a test pressure value and a duration in which the first pressure data is greater than the test pressure value is less than or equal to a preset length of time; and
being configured to perform, when the test state of the battery to be tested (9) is normal, fitting processing on an interfering test value based on the test pressure value, the interfering test value being the first pressure data corresponding to the duration.

2. The battery test tooling according to claim 1, wherein the battery test tooling further comprises an airtightness apparatus (8) and a second pressure sensor (7), the airtightness apparatus (8) being used to perform an airtightness test on the battery to be tested (9), and each of the first pressure sensors (4) being electrically coupled to the airtightness apparatus (8); and the second pressure sensor (7) being electrically coupled to the airtightness apparatus (8) for monitoring an air pressure inside the battery to be tested (9);
preferably,
wherein the structure of the second pressure sensor (7) is adapted to the structure at a gas outlet of the battery to be tested (9), and the second pressure sensor (7) is connectable at the gas outlet of the battery to be tested (9).

3. A use method for the battery test tooling of any one of claims 1 to 2, wherein the battery test tooling comprises an airtightness apparatus (8), driving assemblies (2), and pressing members (3) provided on the driving assemblies (2), the use method comprising:
using a transport member to place a battery to be tested (9) on a test station corresponding to the battery test tooling;
using the driving assemblies (2) to perform a driving action to put the pressing members (3) in motion in a direction approaching the battery to be tested (9) until the pressing members (3) abut against the battery to be tested (9), wherein a pressing face of the pressing member (3) that is close to the battery to be tested (9) is provided with a first pressure sensor (4), the first pressure sensor (4) being used to monitor a pressure value to which the pressing member (3) is subjected; and
using the airtightness apparatus (8) to perform an airtightness test on the battery to be tested (9).

4. The use method for battery test tooling according to claim 3, wherein the battery test tooling comprises at least two sets of said driving assemblies (2), each set of said driving assembly (2) being provided with the pressing member (3), the use method further comprising:
determining, according to the shape of the battery to be tested (9), target pressing members (3) among the pressing members (3), wherein the target pressing members (3) are arranged to form a shape adapted to an abutting surface of the battery to be tested (9); and
removing standby pressing members (3) among the pressing members (3) in the battery test tooling, the pressing members (3) comprising the standby pressing members (3) and the target pressing members (3).

5. A control method for battery test tooling, which is applied to a controller, wherein the battery test tooling comprises an airtightness apparatus (8), driving assemblies (2), and pressing members (3) provided on the driving assemblies (2), the control method comprising:
controlling, in response to a delivery request, a transport member to place a battery to be tested (9) on a test station corresponding to the battery test tooling;
controlling, in response to a test request, the driving assemblies (2) to perform a driving action to put the pressing members (3) in motion in a direction approaching the battery to be tested (9) until the pressing members (3) abut against the battery to be tested (9), **characterized in that** a pressing face of the pressing member (3) that is close to the battery to be tested (9) is provided with first pressure sensors (4)
and further comprising:
controlling the airtightness apparatus (8) to perform an airtightness test on the battery to be tested (9); and
receiving first pressure data monitored by the first pressure sensors (4) and determining a test state of the battery to be tested (9) according to the first pressure data;
wherein the determining the test state of the battery to be tested (9) according to the first pressure data comprises:
judging that the test state of the battery to be tested (9) is normal when the first pressure data is greater than a test pressure value and a duration in which the first pressure data is greater than the test pressure value is less than or equal to a preset length of time; and
performing, when the test state of the battery to be tested (9) is normal, fitting processing on an interfering test value based on the test pressure value, the interfering test value being the first pressure data corresponding to the duration.

6. The control method for battery test tooling according to claim 5,;
wherein the battery test tooling comprises at least two sets of said driving assemblies (2), each set of said driving assembly (2) being provided with the pressing member (3); and the controlling the driving assemblies (2) to perform a driving action to put the pressing members (3) in motion in a direction approaching the battery to be tested (9) until the pressing members (3) abut against the battery to be tested (9) comprises:
controlling, when second pressure values are monitored by the first pressure sensors (4) on target pressing members (3) among the pressing members (3), the driving assemblies (2) corresponding to the target pressing members (3) to stop performing the driving action; and
clearing, when the second pressure value is monitored by the first pressure sensor (4) on each of the target pressing members (3), data of the second pressure value in each of the first pressure sensors (4).

7. The control method for battery test tooling according to any one of claims 5 to 6, wherein the battery test tooling further comprises a bracket (1) and a moving assembly (5), the driving assemblies (2) being mounted on the bracket (1), the bracket (1) being mounted at a mounting station via the moving assembly (5), and the moving assembly (5) being used to put the bracket (1) in motion, the control method further comprising:
determining movement position information of the moving assembly (5) based on process parameters of the battery to be tested (9); and
determining, based on the movement position information, detection position information of the battery test tooling with respect to the battery to be tested (9);
preferably,
wherein the control method further comprises:
acquiring the detection position information in response to a test request; and
controlling, based on the detection position information, the moving assembly (5) to drive the bracket (1) to move so as to put the pressing members (3) in motion to preset positions corresponding to the battery to be tested (9).

## Patentansprüche

1. Batterieprüfwerkzeuge, die Folgendes umfassen:
eine Halterung (1);
wenigstens zwei Sätze von Antriebsanordnungen (2), wobei die Antriebsanordnungen (2) an der Halterung (1) angebracht sind; und
Druckelemente (3), wobei ein Druckelement (3) an jedem Satz der Antriebsanordnung (2) vorgesehen ist, wobei eine Druckfläche an dem Druckelement (3), die von der Halterung (1) entfernt ist, zum Anlegen an eine zu prüfende Batterie (9) verwendet wird; und wobei jedes Druckelement (3) gemäß dem Antrieb der Antriebsanordnung (2) in einer Richtung von der Halterung (1) weg oder zu ihr hin beweglich ist;
**dadurch gekennzeichnet, dass** die Batterieprüfwerkzeuge ferner erste Drucksensoren (4) umfassen, wobei die ersten Drucksensoren (4) an der Druckfläche an jedem der Druckelemente (3) vorgesehen sind und wobei die ersten Drucksensoren (4) verwendet werden, um einen Druck, dem die Druckfläche ausgesetzt ist, wenn das Druckelement (3) an der zu prüfenden Batterie (9) anliegt, zu überwachen; und
wobei die Batterieprüfwerkzeuge ferner eine Steuereinheit umfassen, wobei die ersten Drucksensoren (4) mit der Steuereinheit elektrisch gekoppelt sind und wobei die Steuereinheit konfiguriert ist, erste Druckdaten, die durch die ersten Drucksensoren (4) überwacht werden, zu empfangen und in Übereinstimmung mit den ersten Druckdaten einen Prüfzustand der zu prüfenden Batterie (9) zu bestimmen;
wobei die Steuereinheit, die konfiguriert ist, in Übereinstimmung mit den ersten Druckdaten einen Prüfzustand der zu prüfenden Batterie (9) zu bestimmen, Folgendes umfasst:
dass sie konfiguriert ist zu beurteilen, dass der Prüfzustand der zu prüfenden Batterie (9) normal ist, wenn die ersten Druckdaten größer als ein Prüfdruckwert sind und eine Dauer, in der die ersten Druckdaten größer als der Prüfdruckwert sind, kleiner oder gleich einer im Voraus festgelegten Zeitdauer ist; und
dass sie konfiguriert ist, dann, wenn der Prüfzustand der zu prüfenden Batterie (9) normal ist, auf der Grundlage des Prüfdruckwerts eine Anpassungsverarbeitung an einem störenden Prüfwert auszuführen, wobei der störende Prüfwert auf die ersten Druckdaten, die der Dauer entsprechen, bezogen ist.

2. Batterieprüfwerkzeuge nach Anspruch 1, wobei die Batterieprüfwerkzeuge ferner eine Luftdichtevorrichtung (8) und einen zweiten Drucksensor (7) umfassen, wobei die Luftdichtevorrichtung (8) verwendet wird, um an der zu prüfenden Batterie (9) eine Luftdichteprüfung auszuführen, und wobei jeder der ersten Drucksensoren (4) mit der Luftdichtevorrichtung (8) elektrisch gekoppelt ist; und wobei der zweite Drucksensor (7) zum Überwachen eines Luftdrucks innerhalb der zu prüfenden Batterie (9) mit der Luftdichtevorrichtung (8) elektrisch gekoppelt ist;
wobei vorzugsweise
die Struktur des zweiten Drucksensors (7) an die Struktur eines Gasauslasses der zu prüfenden Batterie (9) angepasst ist und wobei der zweite Drucksensor (7) mit dem Gasauslass der zu prüfenden Batterie (9) verbindbar ist.

3. Verwendungsverfahren für die Batterieprüfwerkzeuge nach einem der Ansprüche 1 bis 2, wobei die Batterieprüfwerkzeuge eine Luftdichtevorrichtung (8), Antriebsanordnungen (2) und Druckelemente (3), die an den Antriebsanordnungen (2) vorgesehen sind, umfassen, wobei das Verwendungsverfahren Folgendes umfasst:
Verwenden eines Transportelements zum Anordnen einer zu prüfenden Batterie (9) an einer Prüfstation, die den Batterieprüfwerkzeugen entspricht;
Verwenden der Antriebsanordnungen (2), um eine Antriebsmaßnahme auszuführen, um die Druckelemente (3) in einer Richtung der Annäherung an die zu prüfende Batterie (9) in Bewegung zu setzen, bis die Druckelemente (3) an der zu prüfenden Batterie (9) anliegen, wobei die Druckfläche des Druckelements (3), die sich in der Nähe der zu prüfenden Batterie (9) befindet, mit einem ersten Drucksensor (4) versehen ist, wobei der erste Drucksensor (4) verwendet wird, um einen Druckwert, dem das Druckelement (3) ausgesetzt ist, zu überwachen; und
Verwenden der Luftdichtevorrichtung (8), um an der zu prüfenden Batterie (9) eine Luftdichteprüfung auszuführen.

4. Verwendungsverfahren für Batterieprüfwerkzeuge nach Anspruch 3, wobei die Batterieprüfwerkzeuge wenigstens zwei Sätze der Antriebsanordnungen (2) umfassen, wobei jeder Satz der Antriebsanordnung (2) mit dem Druckelement (3) versehen ist, wobei das Verwendungsverfahren ferner Folgendes umfasst:
Bestimmen von Zieldruckelementen (3) unter den Druckelementen (3) in Übereinstimmung mit der Form der zu prüfenden Batterie (9), wobei die Zieldruckelemente (3) zum Bilden einer Form, die an eine Stoßfläche der zu prüfenden Batterie (9) angepasst ist, ausgelegt sind; und
Entfernen von Reservedruckelementen (3) unter den Druckelementen (3) in den Batterieprüfwerkzeugen, wobei die Druckelemente (3) die Reservedruckelemente (3) und die Zieldruckelemente (3) umfassen.

5. Steuerverfahren für Batterieprüfwerkzeuge, wobei das Steuerverfahren auf eine Steuereinheit angewendet wird, wobei die Batterieprüfwerkzeuge eine Luftdichtevorrichtung (8), Antriebsanordnungen (2) und Druckelemente (3), die an den Antriebsanordnungen (2) vorgesehen sind, umfassen, wobei das Steuerverfahren Folgendes umfasst:
Steuern eines Transportelements zum Anordnen einer zu prüfenden Batterie (9) in einer Prüfstation, die den Batterieprüfwerkzeugen entspricht, als Reaktion auf eine Zuführungsanforderung;
Steuern der Antriebsanordnungen (2) zum Ausführen einer Antriebsmaßnahme, um die Druckelemente (3) in einer Richtung der Annäherung an die zu prüfende Batterie (9) in Bewegung zu setzen, bis die Druckelemente (3) an der zu prüfenden Batterie (9) anliegen, als Reaktion auf eine Prüfanforderung, **dadurch gekennzeichnet, dass**
eine Druckfläche des Druckelements (3), das sich in der Nähe der zu prüfenden Batterie (9) befindet, mit ersten Drucksensoren (4) versehen ist, und das Verfahren ferner Folgendes umfasst:
Steuern der Luftdichtevorrichtung (8) zum Ausführen einer Luftdichteprüfung an der zu prüfenden Batterie (9); und
Empfangen erster Druckdaten, die durch die ersten Drucksensoren (4) überwacht werden, und Bestimmen eines Prüfzustands der zu prüfenden Batterie (9) in Übereinstimmung mit den ersten Druckdaten;
wobei das Bestimmen des Prüfzustands der zu prüfenden Batterie (9) in Übereinstimmung mit den ersten Druckdaten Folgendes umfasst:
Beurteilen, dass der Prüfzustand der zu prüfenden Batterie (9) normal ist, wenn die ersten Druckdaten größer als ein Prüfdruckwert sind und eine Dauer, in der der die ersten Druckdaten größer als der Prüfdruckwert sind, kleiner oder gleich einer im Voraus festgelegten Zeitdauer ist; und
Ausführen einer Verarbeitung zur Anpassung eines störenden Prüfwerts auf der Grundlage des Prüfdruckwerts, wobei der störende Prüfwert die ersten Druckdaten, die der Dauer entsprechen, sind, wenn der Prüfzustand der zu prüfenden Batterie (9) normal ist.

6. Steuerverfahren für Batterieprüfwerkzeuge nach Anspruch 5,
wobei die Batterieprüfwerkzeuge wenigstens zwei Sätze der Antriebsanordnungen (2) umfassen, wobei jeder Satz der Antriebsanordnung (2) mit dem Druckelement (3) versehen ist; und wobei das Steuern der Antriebsanordnungen (2) zum Ausführen einer Antriebsmaßnahme, um die Druckelemente (3) in einer Richtung der Annäherung an die zu prüfende Batterie (9) in Bewegung zu setzen, bis die Druckelemente (3) an der zu prüfenden Batterie (9) anliegen, Folgendes umfasst:
Steuern der Antriebsanordnungen (2), die den Zieldruckelementen (3) entsprechen, um die Ausführung der Antriebsmaßnahme anzuhalten, wenn durch die ersten Drucksensoren (4) an den Zieldruckelementen (3) unter den Druckelementen (3) zweite Druckwerte überwacht werden; und
Löschen von Daten des zweiten Druckwerts in jedem der ersten Drucksensoren (4), wenn der zweite Druckwert durch den ersten Drucksensor (4) bei jedem der Zieldruckelemente (3) überwacht wird.

7. Steuerverfahren für Batterieprüfwerkzeuge nach einem der Ansprüche 5 bis 6, wobei die Batterieprüfwerkzeuge ferner eine Halterung (1) und eine Bewegungsanordnung (5) umfassen, wobei die Antriebsanordnungen (2) an der Halterung (1) angebracht sind, wobei die Halterung (1) über die Bewegungsanordnung (5) an einer Montagestation angebracht ist, wobei die Bewegungsanordnung (5) verwendet wird, um die Halterung (1) in Bewegung zu setzen, wobei das Steuerverfahren ferner Folgendes umfasst:
Bestimmen von Bewegungspositionsinformationen der Bewegungsanordnung (5) auf der Grundlage von Prozessparametern der zu prüfenden Batterie (9); und
Bestimmen von Detektionspositionsinformationen der Batterieprüfwerkzeuge in Bezug auf die zu prüfende Batterie (9) auf der Grundlage der Bewegungspositionsinformationen;
wobei vorzugsweise
das Steuerverfahren ferner Folgendes umfasst:
Erfassen der Detektionspositionsinformationen in Reaktion auf eine Prüfanforderung; und
Steuern der Bewegungsanordnung (5), um die Halterung (1) anzutreiben, damit sie sich in der Weise bewegt, dass die Druckelemente (3) zu im Voraus festgelegten Positionen, die der zu prüfenden Batterie (9) entsprechen, in Bewegung versetzt werden, auf der Grundlage der Detektionspositionsinformationen.

## Revendications

1. Outillage de test de batterie, comprenant :
un bâti (1) ;
au moins deux jeux d'ensembles d'entraînement (2), les ensembles d'entraînement (2) étant montés sur le bâti (1) ; et
des organes de pression (3), l'organe de pression (3) étant disposé sur chaque jeu desdits ensembles d'entraînement (2), une face de pression sur l'organe de pression (3) éloignée du bâti (1) servant à venir en appui contre une batterie à tester (9) ; et chaque organe de pression (3) étant mobile dans une direction s'éloignant du bâti (1) ou se rapprochant de celui-ci sous l'effet de l'ensemble d'entraînement (2) ;
l'outillage de test de batterie étant **caractérisé en ce qu'**il comprend en outre des premiers capteurs de pression (4), les premiers capteurs de pression (4) étant disposés sur la face de pression de chacun des organes de pression (3), et les premiers capteurs de pression (4) servant à surveiller une pression à laquelle la face de pression est soumise lorsque l'organe de pression (3) vient en appui contre la batterie à tester (9) ; et
l'outillage de test de batterie comprenant en outre un contrôleur, les premiers capteurs de pression (4) étant couplés électriquement au contrôleur, et le contrôleur étant configuré pour recevoir des premières données de pression surveillées par les premiers capteurs de pression (4) et déterminer un état de test de la batterie à tester (9) en fonction des premières données de pression ;
dans lequel le fait que le contrôleur soit configuré pour déterminer un état de test de la batterie à tester (9) en fonction des premières données de pression comprend :
le fait qu'il soit configuré pour établir que l'état de test de la batterie à tester (9) est normal lorsque les premières données de pression sont supérieures à une valeur de pression de test et qu'une durée pendant laquelle les premières données de pression sont supérieures à la valeur de pression de test est inférieure ou égale à un laps de temps prédéfini ; et
le fait qu'il soit configuré pour exécuter, lorsque l'état de test de la batterie à tester (9) est normal, un traitement d'ajustement sur une valeur de test d'interférence sur la base de la valeur de pression de test, la valeur de test d'interférence constituant les premières données de pression correspondant à la durée.

2. Outillage de test de batterie selon la revendication 1, l'outillage de test de batterie comprenant en outre un appareil d'étanchéité (8) et un deuxième capteur de pression (7), l'appareil d'étanchéité (8) servant à exécuter un test d'étanchéité sur la batterie à tester (9), et chacun des premiers capteurs de pression (4) étant couplé électriquement à l'appareil d'étanchéité (8) ; et le deuxième capteur de pression (7) étant couplé électriquement à l'appareil d'étanchéité (8) pour surveiller une pression d'air à l'intérieur de la batterie à tester (9) ;
de préférence,
dans lequel la structure du deuxième capteur de pression (7) est adaptée à la structure au niveau d'une sortie de gaz de la batterie à tester (9), et le deuxième capteur de pression (7) est apte à être raccordé au niveau de la sortie de gaz de la batterie à tester (9).

3. Procédé d'utilisation destiné à l'outillage de test de batterie selon l'une quelconque des revendications 1 à 2, dans lequel l'outillage de test de batterie comprend un appareil d'étanchéité (8), des ensembles d'entraînement (2) et des organes de pression (3) disposés sur les ensembles d'entraînement (2), le procédé d'utilisation comprenant :
l'utilisation d'un organe de transport pour placer une batterie à tester (9) sur une station de test correspondant à l'outillage de test de batterie ;
l'utilisation des ensembles d'entraînement (2) pour exécuter une action d'entraînement afin de mettre en mouvement les organes de pression (3) dans une direction se rapprochant de la batterie à tester (9) jusqu'à ce que les organes de pression (3) viennent en appui contre la batterie à tester (9), une face de pression de l'organe de pression (3) proche de la batterie à tester (9) étant pourvue d'un premier capteur de pression (4), le premier capteur de pression (4) servant à surveiller une valeur de pression à laquelle l'organe de pression (3) est soumis ; et
l'utilisation de l'appareil d'étanchéité (8) pour exécuter un test d'étanchéité sur la batterie à tester (9).

4. Procédé d'utilisation destiné à l'outillage de test de batterie selon la revendication 3, dans lequel l'outillage de test de batterie comprend au moins deux jeux desdits ensembles d'entraînement (2), chaque jeu desdits ensembles d'entraînement (2) étant pourvu de l'organe de pression (3), le procédé d'utilisation comprenant en outre :
la détermination, en fonction de la forme de la batterie à tester (9), d'organes de pression cibles (3) parmi les organes de pression (3), les organes de pression cibles (3) étant agencés de manière à former une forme adaptée à une surface d'appui de la batterie à tester (9) ; et
le retrait d'organes de pression non utilisés (3) parmi les organes de pression (3) dans l'outillage de test de batterie, les organes de pression (3) comprenant les organes de pression non utilisés (3) et les organes de pression cibles (3).

5. Procédé de commande destiné à un outillage de test de batterie, appliqué à un contrôleur, dans lequel l'outillage de test de batterie comprend un appareil d'étanchéité (8), des ensembles d'entraînement (2) et des organes de pression (3) disposés sur les ensembles d'entraînement (2), le procédé de commande comprenant :
la commande, en réponse à une demande d'acheminement, d'un organe de transport pour placer une batterie à tester (9) sur une station de test correspondant à l'outillage de test de batterie ;
la commande, en réponse à une demande de test, des ensembles d'entraînement (2) pour exécuter une action d'entraînement afin de mettre en mouvement les organes de pression (3) dans une direction se rapprochant de la batterie à tester (9) jusqu'à ce que les organes de pression (3) viennent en appui contre la batterie à tester (9), **caractérisé en ce que**
une face de pression de l'organe de pression (3) proche de la batterie à tester (9) est pourvue de premiers capteurs de pression (4), et comprenant en outre :
la commande de l'appareil d'étanchéité (8) pour exécuter un test d'étanchéité sur la batterie à tester (9) ; et
la réception de premières données de pression surveillées par les premiers capteurs de pression (4) et la détermination d'un état de test de la batterie à tester (9) en fonction des premières données de pression ;
dans lequel la détermination de l'état de test de la batterie à tester (9) en fonction des premières données de pression comprend :
l'établissement que l'état de test de la batterie à tester (9) est normal lorsque les premières données de pression sont supérieures à une valeur de pression de test et qu'une durée pendant laquelle les premières données de pression sont supérieures à la valeur de pression de test est inférieure ou égale à un laps de temps prédéfini ; et
l'exécution, lorsque l'état de test de la batterie à tester (9) est normal, d'un traitement d'ajustement sur une valeur de test d'interférence sur la base de la valeur de pression de test, la valeur de test d'interférence constituant les premières données de pression correspondant à la durée.

6. Procédé de commande destiné à un outillage de test de batterie selon la revendication 5,
dans lequel l'outillage de test de batterie comprend au moins deux jeux desdits ensembles d'entraînement (2), chaque jeu desdits ensembles d'entraînement (2) étant pourvu de l'organe de pression (3) ; et la commande des ensembles d'entraînement (2) pour exécuter une action d'entraînement afin de mettre en mouvement les organes de pression (3) dans une direction se rapprochant de la batterie à tester (9) jusqu'à ce que les organes de pression (3) viennent en appui contre la batterie à tester (9) comprend :
la commande, lorsque des deuxièmes valeurs de pression sont surveillées par les premiers capteurs de pression (4) sur des organes de pression cibles (3) parmi les organes de pression (3), des ensembles d'entraînement (2) correspondant aux organes de pression cibles (3) afin d'arrêter l'exécution de l'action d'entraînement ; et
l'effacement, lorsque la deuxième valeur de pression est surveillée par le premier capteur de pression (4) sur chacun des organes de pression cibles (3), des données de la deuxième valeur de pression dans chacun des premiers capteurs de pression (4).

7. Procédé de commande destiné à un outillage de test de batterie selon l'une quelconque des revendications 5 à 6, dans lequel l'outillage de test de batterie comprend en outre un bâti (1) et un ensemble de déplacement (5), les ensembles d'entraînement (2) étant montés sur le bâti (1), le bâti (1) étant monté au niveau d'une station de montage au moyen de l'ensemble de déplacement (5), et l'ensemble de déplacement (5) servant à mettre en mouvement le bâti (1), le procédé de commande comprenant en outre :
la détermination d'informations de position de déplacement de l'ensemble de déplacement (5) sur la base de paramètres de processus de la batterie à tester (9) ; et
la détermination, sur la base des informations de position de déplacement, d'informations de position de détection de l'outillage de test de batterie par rapport à la batterie à tester (9) ;
de préférence,
le procédé de commande comprenant en outre :
l'acquisition des informations de position de détection en réponse à une demande de test ; et
la commande, sur la base des informations de position de détection, de l'ensemble de déplacement (5) pour entraîner le bâti (1) en déplacement de manière à mettre en mouvement les organes de pression (3) jusqu'à des positions prédéfinies correspondant à la batterie à tester (9).
